# EUROPEAN PATENT SPECIFICATION

(11) **EP 2 728 623 B1**
(45) Date of publication and mention of the grant of the patent: **01.05.2019**
(21) Application number: 12805375.8
(22) Date of filing: 29.06.2012
(51) Int. Cl.: H01L 31/04, H01L 31/0216, G02F 1/1335, H01L 31/0392, H01L 31/0463, H01L 31/0224, H01L 31/0236, H01L 31/046, H01L 31/0465

(54) **THIN FILM SOLAR CELL AND METHOD FOR MANUFACTURING SAME**
DÜNNSCHICHT-SOLARZELLE UND VERFAHREN ZU IHRER HERSTELLUNG
PHOTOPILE À COUCHE MINCE ET SON PROCÉDÉ DE FABRICATION

(30) Priority: 30.06.2011 JP 2011146316; 13.09.2011 JP 2011199902
(43) Date of publication of application: 07.05.2014
(73) Proprietor: Kaneka Corporation, Osaka-shi, Osaka 530-8288 (JP)
(72) Inventor: INAKI, Osamu, Settsu-shi, Osaka 566-0072 (JP); MEGURO, Tomomi, Settsu-shi, Osaka 566-0072 (JP); KOIZUMI, Gensuke, Settsu-shi,Osaka 566-0072 (JP); NAKANISHI, Naoaki, Settsu-shi, Osaka 566-0072 (JP); YAMAMOTO, Kenji, Settsu-shi, Osaka 566-0072 (JP)
(74) Representative: Hoffmann Eitle
(86) International application number: PCT/JP2012/066788
(87) International publication number: WO 2013/002394

(56) References cited:
- EP-A1- 1 732 139
- EP-A1- 2 161 759
- EP-A1- 2 296 185
- EP-A2- 0 911 884
- WO-A1-2005/027229
- WO-A1-2009/142156
- DE-A1-102009 006 718
- JP-A- 4 196 364
- JP-A- 7 263 727

## Description

### TECHNICAL FIELD

The invention relates to a thin film solar cell having high light-capturing efficiency and a method for manufacturing the same.

### BACKGROUND ART

A thin film solar cell includes a transparent electrode layer, a photoelectric conversion unit formed of a semiconductor silicon or the like, and a back electrode layer on a transparent substrate. The thin film solar cell is modularized by patterning each layer by laser light irradiation to be divided into a plurality of unit cells, and connecting the unit cells in series or in parallel to be integrated.

One of the measures for improving photoelectric conversion efficiency of the thin film solar cell is "improvement of light confinement efficiency". Light confinement utilizes the following phenomenon: the optical path length of incident light from the transparent substrate side is increased due to light scattering in a transparent electrode layer and a photoelectric conversion layer and refraction of light at the interface between the layers, so that the traveling distance of light passing through the photoelectric conversion unit becomes greater than that in the thickness direction. When the optical path length of incident light is increased, the "apparent thickness" of the photoelectric conversion layer which forms the photoelectric conversion unit increases, so that light absorption increases, and resultantly the short-circuit current may be increased.

As one light confinement method, a method is known in which an irregularity shape is formed on the light incident side of a photoelectric conversion unit. For example, Patent Document 1 describes that a transparent conductive oxide film which forms a transparent electrode layer is configured to have two layers, wherein a so-called "double texture structure" is formed, thereby enhancing the light confinement effect. However, when a transparent conductive oxide layer is formed directly on a smooth base as in Patent Document 1, possibility of design is limited because the crystal structure of the transparent conductive oxide influences the irregularity shape.

As another method for forming an irregularity shape, Patent Document 2 proposes forming an irregularity layer directly on a base by nano-imprint. In Patent Document 2, however, suppression of reflection by a substrate is not sufficient, and there is a room for improvement. When an irregularity layer is formed by nano-imprint on a smooth base such as a glass plate as in Patent Document 2, adhesion between the base and the irregularity layer is not sufficient, and therefore peeling of the layer may occur.

Another method for forming an irregularity shape is a method in which a layer containing fine particles in a binder is formed on a base. For example, in Patent Document 3, Patent Document 4 and Patent Documents EP 1 732 139 A1, EP 2 161 759, DE 10 2009 006718 A1 and EP 0 911 884 A3, a coating solution including particles and a binder is applied onto a glass base to form a fine particle-containing layer having a fine irregularity shape, so that the light confinement effect is improved.

In Patent Document 3, a transparent electrode layer is formed by a sputtering method on an irregularity layer containing fine particles having a particle size of 100 nm or more. In Patent Document 4, a transparent electrode layer is formed by a thermal CVD method on an irregularity layer containing fine particles having a particle size of 50 nm to 200 nm. In Patent Document 3 and Patent Document 4, the direction in which crystals are grown is governed by a conductive oxide material which forms a transparent electrode layer, and a formation method thereof, and a specific irregularity shape is formed on the surface of the transparent electrode layer. Therefore, forming the surface irregularity shape that is optimal for light confinement may be improved.

When a transparent substrate has an irregularity shape, laser processing accuracy and its reliability tend to be deteriorated because laser light is scattered at the irregular interface of the substrate at the time of patterning a thin film solar cell to be integrated. Patent Document 5 proposes improving reproducibility of laser processing by performing processing so as to ensure that irregularity is not formed on an area which does not contribute to power generation (non-photoelectric conversion region). Patent Document 5 proposes, as a method for locally forming irregularities, a method in which an area of an amorphous silicon film is selectively crystallized by laser annealing, followed by removing the silicon film by dry etching. This method has the problem that the process for formation of irregularities is complicated, and it is thus difficult to improve production efficiency of an integrated thin film solar cell.

### PRIOR ART DOCUMENTS

### PATENT DOCUMENTS

Patent Document 1: Japanese Patent Laid-open Publication No. 3-125481
Patent Document 2: International Publication No. WO 2009/157447
Patent Document 3: Japanese Patent Laid-open Publication No. 2003-243676
Patent Document 4: Japanese Patent Laid-open Publication No. 2005-311292
Patent Document 5: Japanese Patent Laid-open Publication No. 2009-224427

### SUMMARY OF THE INVENTION

### PROBLEMS TO BE SOLVED BY THE INVENTION

In view of the situations described above, an object of the invention is to provide a thin film solar cell which is more excellent in anti-reflection effect and light confinement effect than conventional methods by forming a surface irregularity shape suitable for light confinement on a transparent substrate arranged on the light incident side of the thin film solar cell. Further, an object of the invention is to provide a thin film solar cell which is also suitable for integration by laser light irradiation while a surface irregularity shape suitable for light confinement is formed on the surface of the transparent substrate.

### MEANS FOR SOLVING THE PROBLEMS

For achieving the above-described objects, the inventors have conducted studies, and found that the above-described objects are achieved by using a substrate with a specific irregularity pattern.

The invention relates to a thin film solar cell including: a transparent substrate; a transparent electrode layer; at least one photoelectric conversion unit; and a back electrode layer in this order from the light incident side.

The transparent substrate includes a transparent base and a transparent undercoat layer in this order from the light incident side. An insulating irregularity layer has an irregularity pattern on a surface on the transparent electrode layer side. The transparent substrate includes a transparent undercoat layer containing fine particles and a binder between the transparent base and the insulating irregularity layer.

The insulating irregularity layer has a refractive index of 1.40 to 1.65. In addition, the insulating irregularity layer has a height difference of the irregularity pattern in the range of 300 nm to 2000 nm, more preferably in the range of 400 nm to 1500 nm, further preferably in the range of 500 nm to 1300 nm. The height difference is further preferably 500 nm to 1000 nm, especially preferably 500 nm to 800 nm. An insulating irregularity layer including a siloxane-based compound as a main component is preferably used.

The fine particles in the transparent undercoat layer preferably have an average particle size of 10 nm to 350 nm. The average particle size of the fine particles is more preferably 10 nm to 200 nm, further preferably 15 nm to 150 nm. In the transparent undercoat layer, the area coverage with the fine particles is preferably 80% or more. The arithmetic mean roughness Ra of a surface of the transparent undercoat layer on the insulating irregularity layer side is 5 nm to 65 nm, more preferably 5 nm to 50 nm, further preferably 10 nm to 30 nm.

In the present invention, the insulating irregularity layer is formed by nano-imprint method. Specifically, the insulating irregularity layer is formed by: forming a coating layer by applying a coating solution containing a curable material; preliminarily drying the coating layer; pressing a matrix having an irregularity pattern to the preliminarily dried coating layer; curing the curable material of the coating layer; and releasing the matrix from the cured coating layer.

In one embodiment, the viscosity of the coating solution is preferably 0.1 mPa·s to 10 mPa·s, more preferably 0.5 mPa·s to 5 mPa·s, further preferably 1 mPa·s to 2 mPa·s. In one embodiment, the height difference of the irregularity pattern of the matrix is 1.1 to 1.4 times the height difference of the irregularity pattern of the insulating irregularity layer. According to these embodiments, even when the irregularities of the undercoat layer fine particles are large, coatability of a curable material for forming insulating irregularity layer is improved, so that irregularities suitable for light confinement are properly formed.

In one embodiment of the invention, the transparent base includes an anti-reflection layer on a surface on the light incident side of the transparent base. The anti-reflection layer preferably includes fine particles and a binder.

In one embodiment, the thin film solar cell of the present invention includes a plurality of photoelectric conversion regions and a plurality of non-photoelectric conversion regions. In this embodiment, the transparent electrode layer, the photoelectric conversion unit and the back electrode layer are divided by separation grooves formed in the non-photoelectric conversion regions, so as to form a plurality of photoelectric conversion cells. The transparent substrate includes a plurality of light scattering regions and a plurality of flat regions having smaller haze than the light scattering region, and the non-photoelectric conversion region preferably overlaps at least part of the flat region. In a preferred embodiment, the non-photoelectric conversion region is formed in the flat region.

In the insulating irregularity layer, the height difference of the irregularity pattern of a surface on the transparent electrode layer side in the light scattering region is preferably larger than the height difference of the irregularity pattern of a surface on the transparent electrode layer side in the flat region. In the transparent substrate, the haze of the light scattering region is preferably 10 to 50%, and the haze of the flat region is preferably 10% or less.

In the present invention, an integrated solar cell includes a plurality of cells which are connected in series. It is preferable that the transparent electrode layer is divided into a plurality of regions by a transparent electrode layer separation groove, and the photoelectric conversion unit and the back electrode layer are divided into a plurality of regions by a back electrode layer separation groove, so that a plurality of photoelectric conversion cells are formed. In this embodiment, a connection groove formed in the photoelectric conversion unit is filled with a conductive material which forms the back electrode layer, so that the transparent electrode layer and the back electrode layer are electrically connected, and adjacent photoelectric conversion cells are connected in series.

The separation groove and the connection groove may be formed by making laser light incident from the transparent substrate side.

### EFFECTS OF THE INVENTION

According to the present invention, since a transparent substrate has a transparent undercoat layer and an insulating irregularity layer, reflection of light by the transparent substrate is suppressed, and the optical path length of incident light is increased due to light scattering, so that an improved light confinement effect is exhibited. Therefore, a thin film solar cell of the present invention may capture a large amount of light in a photoelectric conversion unit, and resultantly solar cell characteristics may be improved.

### BRIEF DESCRIPTION OF THE DRAWINGS

[FIG. 1] A schematic sectional view of one embodiment of a transparent substrate.
[FIG. 2] A schematic sectional view of one embodiment of a transparent substrate.
[FIG. 3] A schematic sectional view of one embodiment of a thin film solar cell.
[FIG. 4] An atomic force microscope (AFM) observation photograph of the transparent undercoat layer surface of Example 1.
[FIG. 5] A scanning electron microscope (SEM) observation photograph of the cross-section of the transparent substrate of Example 1
[FIG. 6] A schematic sectional view of a construction example of an integrated thin film solar cell.
[FIG. 7] A schematic cross-sectional view of one embodiment of an integrated thin film solar cell.
[FIG. 8] A schematic cross-sectional view of one embodiment of an integrated thin film solar cell.
[FIG. 9] Schematic views of one embodiment of a matrix used for forming an insulating irregularity layer: (A) is a plane view; and (B) is a sectional view along line B-B in (A).
[FIG. 10] A plane view schematically illustrating one embodiment of a matrix used for forming an insulating irregularity layer.
[FIG. 11] Schematic views of one embodiment of a matrix used for forming an insulating irregularity layer: (A) is a plane view; (C) is a sectional view along line C-C in (A); and (B) is a cross-sectional view illustrating a matrix before a flat region is formed.
[FIG. 12] An atomic force microscope (AFM) observation photograph of the undercoat layer surface of Reference Example 1.
[FIG. 13] An atomic force microscope (AFM) observation photograph of the insulating irregularity layer surface of Reference Example 1.
[FIG. 14] An atomic force microscope (AFM) observation photograph of the undercoat layer surface of Reference Example 2.
[FIG. 15] An atomic force microscope (AFM) observation photograph of the insulating irregularity layer surface of Reference Example 2.
[FIG. 16] An atomic force microscope (AFM) observation photograph of the insulating irregularity layer surface of Reference Example 3.

### DESCRIPTION OF EMBODIMENTS

The invention relates to a thin film solar cell having a transparent electrode layer, at least one photoelectric conversion unit and a back electrode layer in this order on a transparent substrate having an insulating irregularity layer. Representative embodiments of the thin film solar cell according to the present invention will be shown below, but the present invention is not limited to these embodiments.

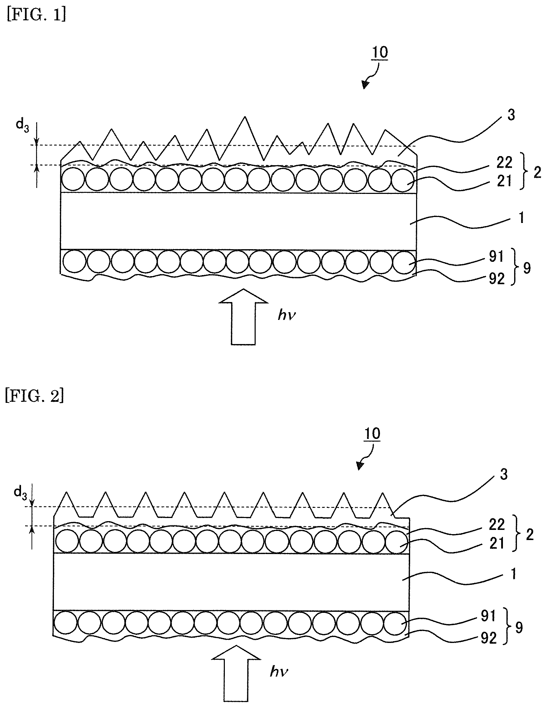

FIGs. 1 and 2 are sectional views each schematically illustrating a transparent substrate with an irregularity pattern according to one embodiment. A transparent substrate 10 in FIG. 1 has on one surface of a transparent base 1 a transparent undercoat layer 2 containing fine particles 21 and a binder 22, and has an insulating irregularity layer 3 thereon. In FIG. 1, aperiodic irregularity structures are formed on the surface of the insulating irregularity layer 3. An anti-reflection layer containing fine particles 91 and a binder 92 is formed on the other surface (surface on the light incident side) of the transparent base 1. The transparent substrate in FIG. 2 has a stacked structure similar to that of the transparent substrate in FIG. 1, but is different from the transparent substrate in FIG. 1 in that periodic irregularity structures are formed on the surface of the insulating irregularity layer 3.

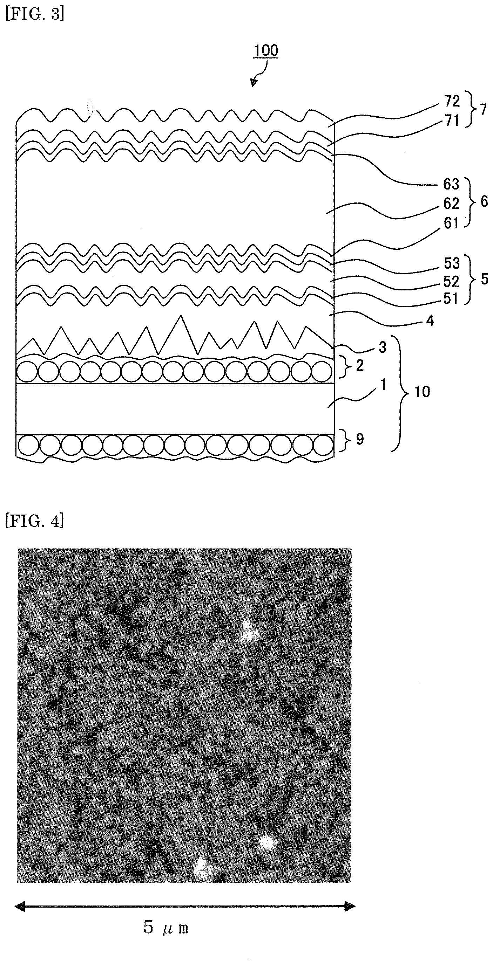

FIG. 3 is a sectional view schematically illustrating a thin film solar cell 100 according to one embodiment. The thin film solar cell 100 has a transparent electrode layer 4, photoelectric conversion units 5 and 6 and a back electrode layer 7 formed in this order on the insulating irregularity layer 3 of the transparent substrate 10. Hereinafter, the transparent substrate 10 on which the transparent electrode layer 4 is formed is referred to as a "substrate with a transparent electrode" in some cases.

### (Transparent Base)

The transparent base 1 is preferably transparent wherever possible, so that larger amount of sunlight is absorbed in the photoelectric conversion units 5 and 6. As the transparent base 1, a glass base, a resin base or the like may be used. It is preferable to use a glass base from the viewpoint of a high transmittance and low costs. Examples of the glass base include, but are not limited to, an alkali-free glass and a soda lime glass. As the transparent base 1, one having a thickness of 0.7 mm to 5.0 mm may be preferably used. A transparent base having a refractive index of about 1.45 to 1.55 may be preferably used.

### (Transparent Undercoat Layer)

The thin film solar cell of the present invention includes, between the transparent base 1 and the insulating irregularity layer 3, a transparent undercoat layer 2 containing fine particles 21 and the binder 22. A difference between the refractive index of the fine particles 21 and the refractive index of the transparent base 1 is preferably 0.1 or less, more preferably 0.05 or less. Specifically, the refractive index of the fine particles 21 is preferably 1.4 to 2.5, more preferably 1.4 to 1.7, further preferably 1.45 to 1.55.

As a material of the fine particles 21, for example, silica (SiO₂), titanium oxide (TiO₂), aluminum oxide (Al₂O₃), zirconium oxide (ZrO₂), indium tin oxide (ITO), magnesium fluoride (MgF₂) or the like is preferably used. When a glass is used as the transparent base 1, the material of the fine particles 21 is especially preferably silica, from the viewpoint of the transparency of the material and compatibility with the glass base.

In the present invention, the average particle size of the fine particles 21 is preferably 10 nm to 350 nm. By using fine particles having an average particle size in the above-mentioned range, an effect of increasing the optical path length of incident sunlight to increase the light absorption amount (light confinement effect) in a photoelectric conversion unit that forms a thin film solar cell can be expected.

For reducing reflection of light at the interface between the fine particles 21 and the binder 22, the average particle size of the fine particles 21 is more preferably 30 nm or more, further preferably 50 nm or more. For effectively scattering short-wavelength light, in particular, of incident light to increase the optical path length, the average particle size of the fine particles 21 is more preferably 200 nm or less, further preferably 150 nm or less, especially preferably 100 nm or less. Further, when the particle size of fine particles is in the aforementioned range, scattering of laser light (for example, YAG laser fundamental wave: 1064 nm and YAG laser second harmonic wave: 532 nm) is suppressed at the time of laser processing in which a separation groove and a connection groove are formed to integrate a thin film solar cell. Thus, reproducibility of laser processing for integration may be improved while efficiency of capturing light in a photoelectric conversion layer is enhanced. Further, when the average particle size of the fine particles 21 is in the aforementioned range, excellent coatability is achieved at the time of applying a solution (curable material) for forming an insulating irregularity layer on the undercoat layer 2. The particle size of the fine particles 21 in the transparent undercoat layer 2 may be determined by scanning electron microscope (SEM) observation. The average particle size is an arithmetic average of the particle sizes of the fine particles in the SEM observation visual field.

The shape of the fine particle 21 is not particularly limited, but is preferably a spherical shape for forming irregularities as uniformly as possible.

As the binder 22, an inorganic material is preferable when long-term reliability and durability in conditions during semiconductor layer deposition (particularly deposition temperature) are considered. Specific examples may include a silicon oxide, an aluminum oxide, a titanium oxide, a zirconium oxide and a tantalum oxide. A difference between the refractive index of the binder 22 and the refractive indices of the transparent base 1 and the fine particles 21 is preferably small. The difference in refractive index is preferably 0.1 or less, more preferably 0.05 or less. Specifically, the refractive index of the binder 22 is preferably 1.45 to 1.55. When the refractive index of the binder 22 in the transparent undercoat layer 2 is in the aforementioned range, reflection of incident light at the interface between the transparent base 1 and the transparent undercoat layer 2 and reflection of light at the surfaces of the fine particles 21 are suppressed, so that the amount of light that reaches the photoelectric conversion units 5 and 6 may be increased. Particularly, when a glass base is used as the transparent base 1 and silica fine particles are used as the fine particles 21, a material having Si as a main component, particularly a silicon oxide, is suitably used as the binder 22, as well as for the materials of the transparent base 1 and the fine particles 21. The silicon oxide is suitable as a material for forming the transparent undercoat layer 2 of the present invention because silicon oxide is excellent in transparency and adhesion strength with glass, and has a refractive index close to that of glass and silica fine particles.

The transparent undercoat layer 2 in the present invention preferably has a refractive index of 1.45 to 1.55. By using the fine particles 21 and binder 22 described above, the refractive index may be kept in the above-described range. In this case, the refractive index of the transparent undercoat layer 2 is a value close to the refractive index of the transparent base 1, and thus an anti-reflection effect at the interface can be expected.

In the transparent undercoat layer 2, the arithmetic mean roughness Ra of a surface on the insulating irregularity layer 3 side is 5 nm to 65 nm. For increasing the surface area of the transparent undercoat layer to improve the adhesive strength with the insulating irregularity layer 3, the arithmetic mean roughness Ra of the surface of the transparent undercoat layer 2 is more preferably 10 nm or more, further preferably 15 nm or more. For improving coatability of a solution for forming the insulating irregularity layer 3 on the transparent undercoat layer 2, the arithmetic mean roughness Ra of the surface of the transparent undercoat layer 2 is preferably 55 nm or less, more preferably 50 nm or less, further preferably 30 nm or less, especially preferably 25 nm or less. The Ra is more preferably 20 nm or less, further preferably 18 nm or less.

The arithmetic mean roughness Ra of the surface of the transparent undercoat layer may be adjusted by changing the particle size and the content of the fine particles 21 in the transparent undercoat layer 2. For example, the Ra tends to increase as the particle size of fine particles is increased. When the coverage is larger than about 80%, as in the present invention, the increasing of the content of fine particles tends to reduce the Ra because projections by fine particles are made adjacent to one another to decrease the height difference of individual projections.

The thickness of the transparent undercoat layer 2 is preferably 50 nm to 200 nm, more preferably 70 nm to 150 nm, further preferably 80 to 120 nm, especially preferably 90 nm to 100 nm. When the thickness of the transparent undercoat layer 2 is in the above-described range, interference of multiple reflection is appropriately adjusted, so that an improved reflection reduction effect is achieved, leading to an enhanced light confinement effect.

The method for forming the transparent undercoat layer 2 on the surface of the transparent base 1 is not particularly limited. A method in which a coating solution containing a binder material and fine particles (hereinafter, referred to simply as a "fine particle-containing coating solution" in some cases) is applied onto the transparent base 1 is desirable. The fine particle-containing coating solution may be prepared by dissolving/dispersing a binder material and fine particles in a solvent. As the solvent, one excellent in binder dissolving property and fine particle dispersing property is suitably used. When silica fine particles are used as the fine particles 21, a mixture of water, an alcohol and hydrochloric acid is preferable as a solvent.

Examples of the method for applying the coating solution to the surface of the transparent base 1 include a dipping method, a spin coating method, a bar coating method, a spraying method, a die coating method, a roll coating method and a flow coating method. Application using a dipping method is preferable when an anti-reflection layer 9 having the fine particles 91 and the binder 92 is formed on the light incident side of the transparent base 1 as described later. In the dipping method, the transparent undercoat layer 2 and the anti-reflection layer 9 may be formed at the same time.

When the fine particle-containing coating solution is applied using a dipping method, it is preferable to perform drying by heating immediately after dipping. For example, the method for drying by heating is preferably a method in which in the initial stage of drying, heating is performed in a windless state to evaporate a solvent to some extent, followed by rising the temperature to about 300°C to solidify the transparent undercoat layer 2.

In the transparent undercoat layer 2, the area coverage with the fine particles 21 is preferably 80% or more, more preferably 90% or more. In the transparent undercoat layer 2 in which the area coverage with fine particles is 80% or more, fine particles are densely arranged as illustrated in, for example, FIG. 4, so that the irregularity pattern of the surface of the transparent undercoat layer has good uniformity, and the height of the irregularity is almost uniform. The area coverage may be adjusted by changing the content of fine particles in the fine particle-containing coating solution. The area coverage may also be adjusted by washing the transparent base 1 to adjust the surface state, and applying a coating solution onto the surface after washing (see, for example, International Publication No. WO 2009/142156).

The "area coverage" is a ratio (occupancy rate) of an area where fine particles are arranged when viewed in a direction perpendicular to the plane of a base. The area coverage may be measured by analyzing a planar image of a transparent undercoat layer which is obtained by AFM measurement.

When the transparent undercoat layer 2 is formed on the transparent base 1 as described above, incident light is scattered to achieve an anti-reflection effect and an optical path length increasing effect of short-wavelength light, and adhesion with the insulating irregularity layer 3 formed on the transparent undercoat layer is improved, so that an air gap (*i.e.* air layer) is hardly generated between the transparent undercoat layer 2 and the insulating irregularity layer 3. Thus, efficiency of light-capturing in a photoelectric conversion layer may be improved.

When the area coverage with fine particles is large, gaps between fine particles are eliminated, and therefore coatability of a solution applied onto the undercoat layer tends to be deteriorated. In the present invention, deterioration of coatability is suppressed by ensuring that the particle size of fine particles is in a specific range as described above. Coatability may also be improved by a method in which a solution (curable material) for forming an insulating irregularity layer is diluted to reduce the viscosity as described later, etc.

### (Anti-reflection Layer)

Preferably the anti-reflection layer 9 is formed on a surface of the transparent base 1 on a side opposite to the transparent undercoat layer 2, *i.e.* a light incident surface. When the anti-reflection layer 9 is present, an anti-reflection effect at the light incident surface of the transparent base 1 can be expected. That is, by providing the anti-reflection layer 9 on the light incident side of the transparent base 1, light is scattered at an interface on the light incident side of the anti-reflection layer 9. Thus, reflection of light at the air interface is suppressed, so that the amount of light captured in the thin film solar cell may be increased.

As the anti-reflection layer 9, one having the fine particles 91 and the binder 92 is preferable, as well as the material for the transparent undercoat layer 2. As the fine particles 91 and the binder 92 in the anti-reflection layer 9, those similar to what have been described above as the fine particles 21 and the binder 22 of the transparent undercoat layer 2 are suitably used.

As a method for forming the anti-reflection layer 9, a method identical to that described above as a method for forming the transparent undercoat layer 2 is suitably adopted. Particularly, the anti-reflection layer 9 having the fine particles 91 and the binder 92 is preferably formed by a dipping method. According to the dipping method, the transparent undercoat layer 2 and the anti-reflection layer 9 may be formed at the same time.

The area coverage with fine particles 21 in the transparent undercoat layer 2 and the area coverage with fine particles 91 in the anti-reflection layer 9 may be the same or different. When the transparent undercoat layer and the anti-reflection layer 9 are formed by a dipping method, a substrate, in which the particle coverage of the transparent undercoat layer 2 and the particle coverage of the anti-reflection layer 9 are different, may be obtained by changing the surface states of both surfaces of the transparent base 1. For example, when the transparent base 1 subjected to a Ceric oxide washing process at a surface on the light incident side (anti-reflection layer 9 forming surface) of the transparent base 1 and subjected to washing with water at the opposite surface (transparent undercoat layer 2 forming surface) is dipped in a fine particle-containing coating solution, the particle coverage of the anti-reflection layer 9 may be made larger than the particle coverage of the transparent undercoat layer 2. Further, the particle coverage of the anti-reflection layer 9 may be made larger than the particle coverage of the transparent undercoat layer 2 by washing both surfaces of the transparent base 1 with Ceric oxide washing process so that the pressing force during washing on the anti-reflection layer 9 forming surface side is higher than the pressing force during washing on the transparent undercoat layer 2 forming surface side.

### (Insulating Irregularity layer)

The insulating irregularity layer 3 has an irregularity pattern on a surface on the transparent electrode layer 4 side. The shape of the irregularity pattern may be aperiodic as schematically illustrated in FIG. 1, or may be periodic as schematically illustrated in FIG. 2. For effectively scattering light over a wider range of wavelengths to enhance the light confinement effect, the irregularity pattern of the surface of the insulating irregularity layer 3 is preferably an aperiodic pattern.

The irregularity pattern may be formed over the entire surface of the insulating irregularity layer 3, or may be formed on a part within the surface. For example, in an integrated thin film solar cell in which each layer is patterned and a plurality of unit cells are connected in series or in parallel, scattering of laser light may be suppressed to enhance accuracy and reproducibility of patterning by laser processing where irregularities are not formed on the surface of an insulating irregularity layer and where the surface is made flat in a non-power generation region that does not contribute to power generation. The configuration of an integrated thin-film photoelectric conversion device and the method for manufacture thereof will be described in detail later. Hereinafter, unless otherwise specified, the shape and the like of the insulating irregularity layer 3 will be described for a region with an irregularity pattern formed on the surface (light scattering region 3B).

The height difference of the irregularities of the surface of the insulating irregularity layer 3 is 300 nm to 2000 nm, more preferably 400 nm to 1500 nm, further preferably 500 nm to 1300 nm. The height difference is further more preferably 500 nm to 1000 nm, especially preferably 500 nm to 800 nm. The maximum height Rmax of the irregularities of the surface of the insulating irregularity layer 3 is preferably 2000 nm or less, more preferably 500 nm to 1500 nm, further preferably 500 nm to 1300 nm or less, further more preferably 500 nm to 1000 nm, especially preferably 500 nm to 800 nm. The distance between apices of projections of the irregularities of the surface of the insulating irregularity layer 3 is preferably 200 nm to 2000 nm, more preferably 500 nm to 800 nm. Since the insulating irregularity layer 3 has the above-described irregularity structures, an anti-reflection effect at an interface on the transparent electrode layer 4 side of the insulating irregularity layer 3 is achieved, and of incident light, particularly long-wavelength light having a wavelength of 500 nm or more may be effectively scattered to increase the optical path length.

The irregularity shape of the surface of the insulating irregularity layer 3 is preferably a pyramid-shape or an inverted pyramid-shape. Alternatively, the irregularity shape may be a honeycomb-shape or a porous structure. The irregularities are preferably continuous. Here, the term "continuous" means that irregularity structures are adjacent with no flat area therebetween.

The height difference and maximum height of the irregularities may be determined from a surface shape of the insulating irregularity layer 3 obtained by, for example, an atomic force microscope (AFM). Specifically, when the surface is scanned with an area of 5 µm × 5 µm using an AFM, the maximum value of height differences between adjacent peaks (apices of projections) and troughs (apices of recesses) in the scanning range is the maximum height. When uniform and periodic irregularity structures are formed on the surface of the insulating irregularity layer 3 as illustrated in FIG. 2, the height difference and the maximum height of the irregularity are substantially equal to each other. On the other hand, when aperiodic irregularity structures are formed on the surface of the insulating irregularity layer 3 as illustrated in FIG. 1, an average value for 20 points in the scanning range is the irregularity height difference. The irregularity height difference for each point is determined as follows: an apex of a projection of one of irregularity structures is randomly selected from the scanning range, and a distance between a line passing through the apex and an apex of another projection, which is adjacent to the aforementioned apex, and an apex of a recess existing between these two apices is measured.

The refractive index of the insulating irregularity layer 3 is 1.40 to 1.65, more preferably 1.55 to 1.60. When the refractive index of the insulating irregularity layer 3 is in the aforementioned range, a difference in refractive index at an interface between the transparent undercoat layer 2 and the insulating irregularity layer 3 or an interface between the transparent base 1 and the insulating irregularity layer 3 is decreased to suppress reflection of incident light, so that the amount of light which reaches the photoelectric conversion units 5 and 6 may be increased.

The insulating irregularity layer 3 may be formed by, for example, a method of laminating transparent films having surface irregularity structures; a method of roughening the surface of a resin layer or the like by sand blasting, polishing or the like; a method of forming irregularity structures on the surface of a resin layer or the like by a combination of lithography and etching; a method of forming irregularity structures on the surface of a resin layer by a nano-imprint method; or the like. In the present invention the insulating irregularity layer 3 is formed by a nano-imprint method because an irregularity pattern may be formed at a low cost. In the nano-imprint method, a heat-curable material or an ultraviolet ray-curable material is suitably used as a material for forming the insulating irregularity layer 3.

The heat-curable material is preferably a sol-gel material obtained by subjecting a metalloxane compound or the like to hydrolysis and condensation polymerization and dispersing a colloidal product thus formed in a solution, or the like. Particularly, one having a siloxane-based compound as a main component may be suitably used. Here, the phrase "having a siloxane-based compound as a main component" means that among materials (solid components) contained in a coating solution, a siloxane-based component is contained in an amount of more than 50% by weight, preferably 70% by weight or more, more preferably 80% by weight or more. For the material having a siloxane-based compound as a main component, a spin-on glass (SOG) material is preferred.

Particularly, for appropriately adjusting the refractive index of a cured film, a material containing 0.1 to 5.0 parts by weight of a titanoxane compound based on 100 parts by weight of the siloxane-based compound is preferable. The titanoxane compound (refractive index: about 1.85 to 2.15) has a refractive index higher than that of the siloxane-based compound (refractive index: about 1.35 to 1.45). Therefore, by adding a titanoxane compound in a siloxane-based compound, the refractive index of the cured film (insulating irregularity layer) may be made closer to the refractive indices of the transparent base 1 and the transparent undercoat layer 2 to reduce reflection at the interface.

As the ultraviolet ray-curable material, a silicone-based material or acryl-based material having an epoxy group is suitably used.

In the nano-imprint method, the insulating irregularity layer 3 is formed by the following steps (A) to (E):
(A) a step of forming a coating layer by applying a coating solution containing a curable material onto the transparent base 1 or the transparent undercoat layer 2;
(B) a step of preliminarily drying the coating layer;
(C) a step of pressing a matrix having irregularity structures to the preliminarily dried coating layer;
(D) a step of curing the curable material; and
(E) a step of releasing the matrix.

As the coating solution containing a curable material, a solution of the aforementioned curable material is used. As a solvent of the coating solution, an alcohol or the like is used. For example, a metalloxane compound is used as the curable material, a mixed solvent of ethyl alcohol and butyl alcohol is preferably used from the viewpoint of stability of an oligomer in the solution, *i.e.* suppression of a self-condensation reaction of metalloxane in the solution.

The preferred range of the solid concentration of the coating solution (curable material solution) varies depending on a curable material, but is generally preferably 5 % by weight to 12% by weight, more preferably 8% by weight to 10% by weight. The viscosity of the solution is preferably 0.1 mPa·s to 10 mPa·s, more preferably 0.5 mPa·s to 5 mPa·s, further preferably 1 mPa·s to 2 mPa·s. By using a curable material solution having the above-mentioned viscosity, coatability of the curable material solution onto the transparent undercoat layer 2 is improved, so that an insulating irregularity layer which fills even in recesses of the surface of the transparent undercoat layer 2 with curable material is formed. Therefore reflection at an interface between the transparent undercoat layer 2 and the insulating irregularity layer 3 may be prevented. The viscosity of the solution is measured at a solution temperature of 25°C using a tuning fork vibratory viscometer.

Generally, a base material as an undercoat is preferably smooth for enhancing formability and imprint processability of an imprint material. In the present invention, on the other hand, irregularities with fine particles are formed on the surface of the transparent undercoat layer 2 as an undercoat for application of an imprint material, in order to enhance light confinement efficiency of a thin film solar cell by reducing the reflectance at a substrate. As described above, in the present invention, by reducing the particle size of the fine particles 21 contained in the transparent undercoat layer 2, the size of the irregularities of the surface of the undercoat layer may be adjusted to improve formability (coatability) of the imprint material.

In a general nano-imprint method, the imprint material is used at a high solid concentration without being diluted because reproducibility of a processed shape is required. On the other hand, in an irregularity layer intended for light scattering as in the present invention, formation of each irregularity shape with high reproducibility is not particularly required as long as the irregularity pattern has a specific height difference as described above. Therefore, in the present invention, particularly when the arithmetic mean roughness Ra of the surface of the transparent undercoat layer 2 is 10 nm or more, the imprint material may be used after being diluted so that the viscosity is in the aforementioned range in order to enhance coatability. Particularly, when the arithmetic mean roughness Ra of the surface of the transparent undercoat layer 2 is 30 nm or more, the imprint material is preferably diluted so that the viscosity is adjusted in the aforementioned range.

Examples of the method for applying a coating solution of the curable material include a dipping method, a spin coating method, a bar coating method, a spray coating method, a die coating method, a roll coating method and a flow coating method. The spin coating method is preferable because the coating solution may be uniformly applied in a small thickness. The thickness of a coating layer is appropriately adjusted according to a desired thickness of the insulating irregularity layer.

Examples of the method for preliminarily drying a coating solution include drying methods using an oven or a hot plate. The drying temperature is, for example, about 40 to 90°C. When a material having a siloxane-based compound is used as the curable material, the drying temperature is preferably about 70°C.

When the imprint material is diluted for adjusting the solution viscosity, a solvent may not be sufficiently removed in the preliminary drying step. If removal of the solvent in preliminary drying is insufficient, reproducibility of formation of irregularities may be deteriorated because the insulating irregularity layer is shrunk due to volatilization of a remaining solvent during heat curing or during firing after releasing of a matrix. In the present invention, however, particularly when the insulating irregularity layer 3 has an aperiodic irregularity pattern, high reproducibility is not required for each irregularity's shape, and therefore a solvent may remain in the coating layer after preliminary drying. In this case, it is preferable that the shape of the matrix (particularly irregularity height difference of matrix) is designed so that the irregularity height difference of the insulating irregularity layer after curing is in a desired range.

Nano-imprint is performed by pressing a matrix onto a coating layer. After or concurrently with pressing the matrix, curing of an imprint material is performed. Specifically, heating is performed in heat nano-imprint, and ultraviolet ray irradiation is performed in ultraviolet-ray nano-imprint. After curing, the matrix is released. In heat nano-imprint, firing of the insulating irregularity layer is preferably performed after the matrix is released.

As a matrix having irregularity structures, for example, a silicon wafer, a nickel electroformed mold, a quartz mold or the like may be used. In heat nano-imprint where a heat-curable material is used, a silicon wafer is suitably used from the viewpoint of ease of forming an irregularity pattern. In ultraviolet-ray nano-imprint where an ultraviolet ray-curable material is used, a quartz mold is suitably used because the matrix is required to transmit ultraviolet light.

As a method for manufacturing a matrix using a silicon wafer, a method is preferable in which a silicon wafer is wet-etched using a strong base such as an aqueous potassium hydroxide solution to form irregularity structures as described in "Yoichiro Nishimoto, Surface Technology, Vol. 56, No. 1 (2005)". A mold prepared in this method may be used directly as a matrix for nano-imprint. Alternatively, a mold formed by transferring a structure, on the basis of the above-described mold, to another material by a method such as electroforming and imprint may be used as a matrix.

The irregularity shape of the matrix is appropriately designed so that the insulating irregularity layer 3 has a desired irregularity shape (irregularity size). The irregularity pattern of the matrix may be a periodic pattern or may be an aperiodic pattern depending on a desired shape of the insulating irregularity layer 3. When the imprint material is used after being diluted for improvement of coatability, etc., the irregularity height difference of the surface of the insulating irregularity layer tends to be smaller than the irregularity height difference of the matrix due to a solvent remaining in the coating layer after preliminary drying. In this case, considering the amount of shrinkage of the insulating irregularity layer in the curing step and the firing step, the irregularity height difference of the matrix is preferably 1.1 times to 1.4 times, more preferably 1.1 times to 1.3 times, further preferably 1.15 times to 1.25 times the irregularity height difference of the surface of the insulating irregularity layer. That is, in one embodiment of the present invention, nano-imprint is performed using a matrix having an irregularity height difference which is 1.1 times to 1.4 times, more preferably 1.1 times to 1.3 times, further preferably 1.15 times to 1.25 times compared to the surface irregularities of the insulating irregularity layer.

The matrix may be surface-treated using a known mold release agent. When the matrix is subjected to a mold release treatment, a burr defect in nano-imprint is reduced, so that irregularity structures may be accurately transferred, and durability of the matrix for repeated use is improved.

The thickness of the insulating irregularity layer 3 is preferably 300 to 2000 nm, more preferably 400 nm to 1500 nm, further preferably 500 nm to 1300 nm. The thickness is further more preferably 500 nm to 1000 nm, especially preferably 500 to 800 nm. When the thickness is in the above-mentioned range, pattern formation which sufficiently reflects a reversal pattern of the matrix can be expected. Here, the thickness d₃ of the insulating irregularity layer 3 is expressed by an average of the thicknesses at a plurality of sites. Specifically, the thickness d₃ is defined by a distance between the bottom surface of the insulating irregularity layer and the center line of the irregularities. When the insulating irregularity layer is formed on the transparent undercoat layer 2 having surface irregularities, the thickness d₃ of the insulating irregularity layer 3 is defined by a distance between the center line of the surface of the transparent undercoat layer 2 (interface with insulating irregularity layer) and the center line of the irregularities of the insulating irregularity layer 3 (see FIGs. 1 and 2).

When the thickness of the insulating irregularity layer is in the above-described range, the irregularity structures of the matrix may be accurately transferred. Particularly, by making the thickness of the insulating irregularity layer larger than the height difference of irregularity structures of the matrix, the whole matrix may be pressed to the coating layer, and therefore irregularity structures may be formed over the entire film surface of the insulating irregularity layer.

### (Transparent Substrate)

As described above, the undercoat layer and the insulating irregularity layer are formed on the transparent base to obtain the transparent substrate 10 with an irregularity pattern according to the present invention. The transparent substrate 10 may have still other layers between the above-described layers as long as the feature of the present invention is not impaired.

The haze of the transparent substrate 10 is preferably 10% or more, more preferably 40% or more, further preferably 50% or more, especially preferably 60% or more. When the haze of the transparent substrate 10 is in the aforementioned range, a sufficient light confinement effect can be expected. On the other hand, the haze of the transparent substrate 10 is preferably 80% or less for suppressing generation of defects in a photoelectric conversion unit formed on the insulating irregularity layer.

### (Transparent Electrode Layer)

The transparent electrode layer 4 in the present invention is preferably electroconductive, and preferably has a high transparency in a wavelength range of 350 to 1500 nm. As a material for the transparent electrode layer, a conductive oxide is preferable, and particularly a material having zinc oxide or indium tin oxide is preferable from the viewpoint of electroconductivity and transparency. The oxide may be a material doped with boron, aluminum, gallium, tin, zinc or the like. The thickness of the transparent electrode layer 4 is preferably 100 to 2000 nm. When the thickness is in the above-mentioned range, it can be expected to obtain a transparent electrode layer having an appropriate resistivity and transparency.

The method for forming the transparent electrode layer 4 is preferably a vapor deposition method. Examples of the vapor deposition method include "physical vapor deposition (PVD) methods" such as a sputtering method, a pulse laser deposition method and an ion vapor deposition method, and "chemical vapor deposition (CVD) methods" such as an organic metal CVD (MOCVD) method and a plasma-enhanced CVD method, and "physical vapor deposition methods".

Among these formation methods, CVD methods are preferable. When the transparent electrode layer 4 is formed by a CVD method, a fine irregularity shape is formed on the surface thereof, so that it can be expected to enhance incident light-capturing efficiency in a wider wavelength range.

The transparent electrode layer 4 may be composed of only one layer, or may be composed of a plurality of layers. When the transparent electrode layer is composed of a plurality of layers, a higher light confinement effect can be expected by employing a double texture structure composed of a two-layer transparent conductive film as disclosed in, for example, International Publication No. WO 2010/090142. In this double texture structure, the irregularity size at an interface on the photoelectric conversion unit 5 side of the transparent electrode layer 4 is small, and therefore generation of defects is suppressed when a semiconductor layer is formed on the transparent electrode layer 4. Accordingly, a thin film photoelectric conversion device having a high open circuit voltage (Voc) is easily obtained in addition to improvement of the short-circuit current density (Jsc) due to light confinement effect.

### (Photoelectric Conversion Unit)

The thin film solar cell of the present invention has at least one photoelectric conversion unit. The photoelectric conversion unit includes, for example, a silicon-based semiconductor layer, a germanium semiconductor layer, a compound semiconductor layer such as CdTe, CIS and CIGS. The silicon-based semiconductor layer may contain only silicon as a main element, or may be an alloy material which contains, in addition thereto, elements such as carbon, oxygen, nitrogen and germanium. Each of the photoelectric conversion units 5 and 6 preferably has a pin junction composed of a p-type layer 51 or 61, a photoelectric conversion layer (i-type layer) 52 or 62 and an n-type layer 53 or 63. Each photoelectric conversion unit may have an n-type layer, an i-type layer and a p-type layer in this order from the light incident side.

FIG. 3 illustrates a double-junction thin film solar cell having the front photoelectric conversion unit 5 on the transparent electrode layer 4 side (light incident side) and the rear photoelectric conversion unit 6 on the back electrode layer 7 side. For example, when the wide band-gap front photoelectric conversion unit (amorphous photoelectric conversion unit) 5 using amorphous silicon as a photoelectric conversion layer 52 and the narrow band-gap rear photoelectric conversion unit (crystalline photoelectric conversion unit) 6 using crystalline silicon as a photoelectric conversion layer 62 are stacked, a thin film solar cell excellent in conversion efficiency may be provided because a wide range of light in a principal wavelength range (400 to 1200 nm) of sunlight may be utilized for photoelectric conversion.

Particularly, when the transparent substrate 10 includes the transparent undercoat layer 2 and the insulating irregularity layer 3 which contain fine particles, light confinement efficiency is improved in the wide range of principal wavelengths of sunlight by the transparent substrate 10, and therefore conversion efficiency of a multi-junction thin film solar cell having a plurality of photoelectric conversion units of different band gaps may be effectively improved.

When the irregularity height of the surface of the insulating irregularity layer 3 is in a range of 300 nm to 2000 nm, light with a long wavelength range, which has a wavelength of 700 nm or more, is effectively scattered. Therefore, the thin film solar cell of the present invention preferably includes a photoelectric conversion unit including a semiconductor layer having a light absorption in the above-mentioned wavelength range as a photoelectric conversion layer. Examples of the semiconductor layer include silicon-based semiconductor layers such as those of polycrystalline silicon and microcrystalline silicon, germanium semiconductor layers and compound (CdTe, CIS, CIGS, etc.) semiconductor layers.

Further, when the fine particles 21 of the transparent undercoat layer 2 have an average particle size in the aforementioned range, light having shorter wavelengths of principal wavelengths of sunlight is effectively scattered to increase the optical path length. Therefore, the thin film solar cell of the present invention may have particularly high conversion efficiency when it includes as the rear conversion unit 6 a photoelectric conversion unit including a semiconductor layer having a light absorption in a long wavelength range as described above, and includes as the front photoelectric conversion unit 5 an amorphous silicon-based photoelectric conversion unit having as the photoelectric conversion layer 52 an amorphous silicon-based material such as amorphous silicon, amorphous silicon carbide or amorphous silicon germanium.

The photoelectric conversion units and semiconductor layers that form the photoelectric conversion units may be formed by various kinds of known methods. For example, the crystalline silicon-based photoelectric conversion unit is formed by depositing a p-type layer, an i-type layer (photoelectric conversion layer) and an n-type layer in order by a plasma-enhanced CVD method. Specific examples include a photoelectric conversion unit formed by depositing a p-type microcrystalline silicon layer 61, an intrinsic (i-type) microcrystalline silicon layer 62 as a photoelectric conversion layer, and an n-type microcrystalline silicon layer 63 in this order.

The p-type microcrystalline silicon layer 61 is formed by introducing, for example, silane, diborane and hydrogen into a chamber as deposition gases. The thickness is preferably 5 nm to 50 nm, more preferably 10 nm to 30 nm, from the viewpoint of suppression of light absorption. The i-type microcrystalline silicon layer 62 is formed in a thickness of about 0.5 µm to 3.5 µm by introducing, for example, silane and hydrogen as deposition gases. The n-type microcrystalline silicon layer 63 is formed by introducing, for example, silane, phosphine and hydrogen into a chamber as deposition gases. The thickness is preferably 5 nm to 50 nm, more preferably 10 nm to 30 nm, from the viewpoint of suppression of light absorption.

In FIG. 3, an embodiment having the amorphous silicon-based photoelectric conversion unit 5 as the front photoelectric conversion unit and having the crystalline silicon-based photoelectric conversion unit 6 as the rear photoelectric conversion unit is described, but the present invention is not limited to this embodiment. As described above, photoelectric conversion units including various kinds of semiconductor layers may be employed. In each photoelectric conversion unit, crystal structures of the p layer/i layer/n layer may be different. The thin film solar cell of the present invention is not limited to a double-junction type as illustrated in FIG. 3, but may have only one photoelectric conversion unit, or may have three or more photoelectric conversion units.

When the thin film solar cell has a plurality of photoelectric conversion units 5 and 6, utilization efficiency of light may be enhanced by reflecting short-wavelength light to the front photoelectric conversion unit 5 side and transmitting long-wavelength light to the rear photoelectric conversion unit 6 side by providing an intermediate reflection layer (not illustrated) at an interface between the photoelectric conversion units for selectively reflecting and transmitting light.

A layer which can improve electrical contact between the transparent electrode layer 4 and the photoelectric conversion unit 5 may be provided therebetween. For example, by providing a semiconductor layer having a band gap wider than that of the photoelectric conversion unit 5, such as a p-type amorphous silicon carbide layer, recombination of electrons-holes in the vicinity of an interface between the transparent electrode layer 4 and the photoelectric conversion unit 5 may be suppressed. As a result, electrons and holes generated at the photoelectric conversion layer 52 may be efficiently taken out into electrodes 4 and 7.

### (Back Electrode Layer)

The back electrode layer 7 is formed on the photoelectric conversion unit 6. Examples of the back electrode layer 7 include those composed of two layers: a conductive oxide layer 71 and a metal layer 72, as illustrated in, for example, FIG. 3. The back electrode layer 7 may have only one of the conductive oxide layer and the metal layer. Other layers may be further provided to form a structure of three or more layers.

When the back electrode layer 7 is composed of the conductive oxide layer 71 and the metal layer 72, the conductive oxide layer 71 may contribute to suppression of mutual diffusion of atoms such as silicon which form the photoelectric conversion unit 6 and metal atoms which form the metal layer 72, and improvement of adhesion of the metal layer 72. By appropriately designing the thickness of the conductive oxide layer 71, multiple interference of reflected light at the conductive oxide film interface may also be controlled to enhance the reflectance of light of any wavelength to the photoelectric conversion unit side.

For suppressing diffusion of atoms between layers while securing reflection properties, the thickness of the conductive oxide layer 71 is preferably in a range of 25 nm to 120 nm, more preferably in a range of 30 to 85 nm. The conductive oxide layer 71 is preferably formed of a transparent conductive oxide which is transparent and is electroconductive, and for example, one having indium oxide, zinc oxide or titanium oxide as a main component may be used.

The metal layer 72 is preferably one having high electroconductivity and a high reflectance. Examples of the above-mentioned material include silver and aluminum. The surfaces of the metal layer 72 on the light incident side and the opposite side have an arithmetic mean roughness Ra of preferably about 5 nm to 150 nm, more preferably 10 nm to 80 nm. The maximum height Rmax of the irregularities is preferably 300 nm to 1000 nm, more preferably 400 nm to 800 nm. When the Ra and the Rmax are in the aforementioned range, light-capturing efficiency may be improved because incident light, which has not been absorbed in the photoelectric conversion units 5 and 6, is efficiently reflected to the sides of the photoelectric conversion units 5 and 6 by the metal layer 72.

The arithmetic mean roughness Ra and the maximum height Rmax of the irregularities of the insulating irregularity layer 3 in the present invention are preferably larger than the Ra and the Rmax, respectively, of the surface of the back electrode layer.

### [Integrated Thin Film Solar Cell]

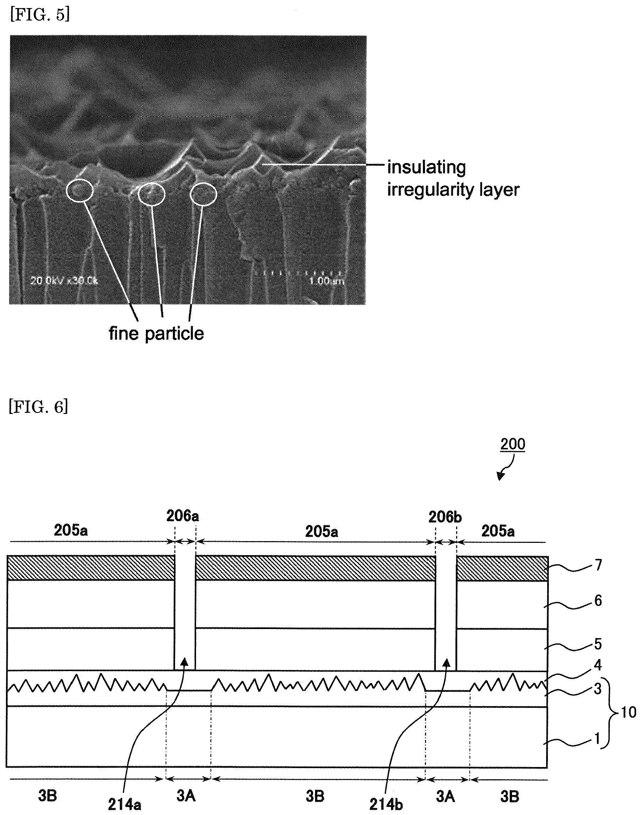

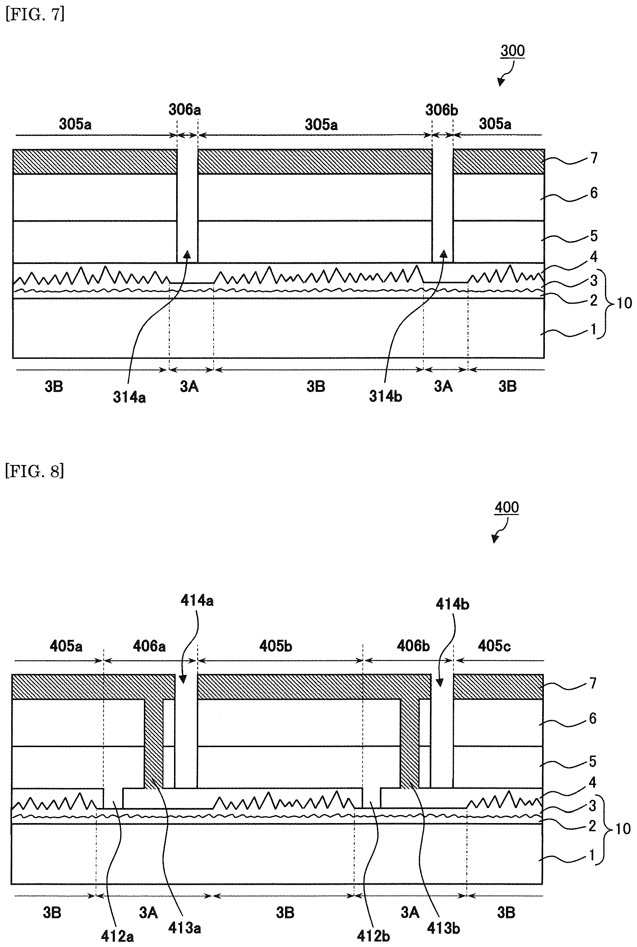

Next, the integrated thin film solar cell of the present invention will be described. FIGs. 6 to 8 are sectional views each schematically illustrating an integrated thin film solar cell. In an integrated thin film solar cell 200 in FIG. 6, the transparent electrode layer 4, the photoelectric conversion units 5 and 6 and the back electrode layer 7 are formed in this order on the insulating irregularity layer 3 of the transparent substrate 10 provided with the insulating irregularity layer 3 on one surface of the transparent base 1. In integrated thin film solar cells 300 and 400 in FIGs. 7 and 8 are different in stacking structure from the integrated thin film solar cell 200 in FIG. 6 in that in the transparent substrate 10, the transparent undercoat layer 2 containing fine particles and a binder is formed on the transparent base 1, and the insulating irregularity layer 3 is formed thereon. In the embodiments of FIGs. 6 and 7, generally a plurality of cells are connected in series or in parallel through a bus bar (not illustrated).

In the integrated thin film solar cell of the present invention, the configurations of the transparent base 1, the transparent undercoat layer 2, the insulating irregularity layer 3, the transparent electrode layer 4, the photoelectric conversion units 5 and 6 and the back electrode layer 7, and the methods for formation thereof, etc. are as described previously with reference to FIGs. 1 to 3. In the integrated thin film solar cell of the present invention, the transparent substrate 10 preferably has on the transparent base 1 the transparent undercoat layer 2 containing fine particles and a binder as illustrated in FIGs. 7 and 8, but the insulating irregularity layer 3 may be formed directly on the transparent base 1 as illustrated in FIG. 6.

In the integrated thin film solar cells 200 and 300 illustrated in FIGs. 6 and 7, the transparent electrode layer 4, the photoelectric conversion units 5 and 6 and the back electrode layer 7 are separated into a plurality of photoelectric conversion cells by separation grooves 214 and 314. In the configuration, regions 206 and 306 provided with the separation grooves 214 and 314 are non-photoelectric conversion regions which do not contribute to photoelectric conversion.

In the integrated thin film solar cell 400 illustrated in FIG. 8, the transparent electrode layer 4 is divided into a plurality of regions by a transparent electrode layer separation groove 412, and the photoelectric conversion units 5 and 6 and the back electrode layer 7 are divided into a plurality of regions by a separation groove 414, so that a plurality of photoelectric conversion cells are formed. Connection grooves 413a and 413b are filled with an electroconductive material that forms the back electrode layer 7, the transparent electrode layer 4 and the back electrode layer 7 are electrically connected, and adjacent photoelectric conversion cells are mutually connected in series. In this configuration, regions provided with separation grooves and connection grooves for integration, *i.e.* a region 406a extending from a transparent electrode layer separation groove 412a to a back electrode layer separation groove 414a and a region 406b extending from a transparent electrode layer separation groove 412b to a back electrode layer separation groove 414b, are non-photoelectric conversion regions which do not contribute to photoelectric conversion.

The separation grooves 214, 314, 414 and 412 and connection grooves 413 may be formed by, for example, mechanical scribing or laser scribing, but is preferably formed by laser scribing using laser beam irradiation from the viewpoint of productivity. Generally, the separation grooves and connection grooves are formed by making laser light incident in the back electrode layer 7 direction from the transparent substrate 10 side.

In the integrated thin film solar cell of the present invention, the transparent substrate 10 preferably has a plurality of flat regions 3A and a plurality of light scattering regions 3B. The light scattering region 3B is a region where the aforementioned periodic or aperiodic irregularity pattern having a specific shape is formed on a surface of the insulating irregularity layer 3 on the transparent electrode layer 4 side. The flat region 3A has no irregularity pattern on the surface of the insulating irregularity layer 3, or has irregularities with smaller height difference as compared to the light scattering region 3B.

For suppressing scattering of laser light for forming separation grooves and connection grooves, the irregularity height difference of the surface of the insulating irregularity layer in the flat region 3A is preferably 20 nm or less, more preferably 10 nm or less. Preferably the flat region 3A has an irregularity height difference of 0, *i.e.* has no irregularity pattern on the surface of the insulating irregularity layer.

In the transparent substrate 10, the haze in the light scattering region 3B is preferably higher than the haze in the flat region 3A. As described above, the haze in the light scattering region 3B is preferably 10% or more, more preferably 40% or more, further preferably 50% or more, especially preferably 60% or more. The flat region 3A preferably has no influences on straight advance properties of laser light, and from such a viewpoint, the haze of the flat region 3A is preferably as low as possible. Specifically, the haze in the flat region 3A of the transparent substrate 10 is preferably less than 10%, more preferably 5% or less. The haze rate in the flat region 3A is ideally 0, but when the haze of the flat region 3A is in the order of several percent, influences on straight advance properties of laser light may be negligible.

When the transparent substrate 10 includes the transparent undercoat layer 2 containing a binder and fine particles, adhesion between the undercoat layer 2 and the insulating irregularity layer 3 is improved, so that peeling between the layers is suppressed even if laser processing is performed. Therefore, a configuration in which the insulating irregularity layer 3 is formed on the transparent base 1 with the transparent undercoat layer 2 interposed therebetween is preferable from the viewpoint of improvement of processability and conversion properties when integration is performed by laser processing.

In the integrated thin film solar cell of the present invention, the non-photoelectric conversion regions 206, 306 and 406 preferably overlap at least part of the flat region 3A. That is to say, it is preferable that the separation grooves 214, 314, 414 and 412 and connection grooves 413 are at least partially formed on the flat region 3A. According to this configuration, laser scribing is performed by irradiating the flat region 3A of the transparent substrate 10 with laser light, and therefore scattering of laser light at the insulating irregularity layer 3 is suppressed to enhance processing accuracy and reproducibility.

The phrase non-photoelectric conversion regions "overlap at least part of' the flat region means that the non-photoelectric conversion regions may straddle both the flat region 3A and the light scattering region 3B. The separation grooves and connection grooves are preferably wholly formed on the flat region 3A for preventing light scattering during laser processing to enhance accuracy and reproducibility of processing, and reducing damage to the photoelectric conversion unit during processing to improve solar cell characteristics. That is, in the integrated thin film solar cell of the present invention, non-photoelectric conversion regions are preferably encompassed by the flat region 3A.

On the other hand, the photoelectric conversion regions 205, 305 and 405 are preferably formed on the light scattering region 3B for enhancing the light confinement effect by the insulating irregularity layer 3. Considering the above together, ideally the flat region 3A is coincident with the non-photoelectric conversion regions 206, 306 and 406 and the light scattering region 3B is coincident with the photoelectric conversion regions 205, 305 and 405.

The insulating irregularity layer 3 having the flat region 3A and the light scattering region 3B is formed by, for example, a nano-imprint method. In the nano-imprint method, the flat region 3A and the light scattering region 3B are formed by a method: (i) in which a matrix having an irregularity structure formed region and an irregularity structure non-formed region is pressed to a coating layer of a curable material; or (ii) in which a print region where a matrix provided with irregularity structures is pressed to a coating layer and a non-print region where pressing to a coating layer is not performed are provided, etc. The method using a matrix having an irregularity structure formed region and an irregularity structure non-formed region is preferable from the viewpoint of processability.

When such a matrix is used, the irregularity structure formed region of the matrix corresponds to the light scattering region 3B and the irregularity structure non-formed region corresponds to the flat region 3A. The shapes of the irregularity structure formed region and the irregularity structure non-formed region are not particularly limited, and are appropriately designed according to the shapes of the light scattering region and the flat region of the integrated thin film solar cell. That is to say, it is preferable that the irregularity structure formed region is appropriately designed according to the shape and size of the photoelectric conversion region of the integrated thin film solar cell.

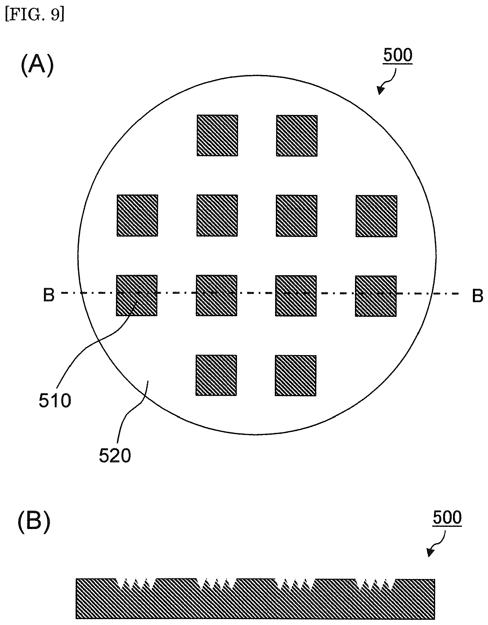

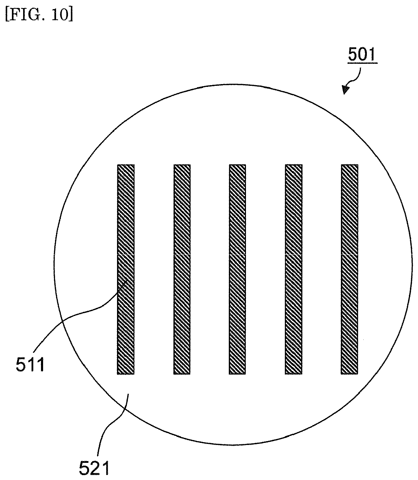

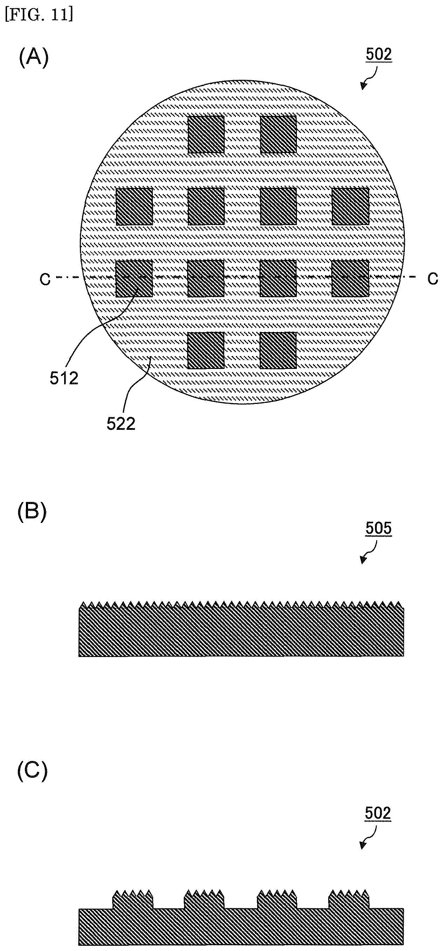

FIGs. 9 to 11 are views each schematically illustrating an example of a matrix having an irregularity structure formed region and an irregularity structure non-formed region. FIG. 9(A) is a plan view of a matrix 500, and FIG. 9(B) is a sectional view along line B-B in FIG. 9(A). FIG. 10 is a plan view of a matrix 501. FIG. 11(A) is a plan view of a matrix 502, and FIG. 11(C) is a sectional view along line C-C in FIG. 11(A). FIG. 11(B) is a sectional view illustrating a matrix 505 having irregularity structures over the entire surface before a flat region 522 is formed.

In FIG. 9(A), each of 12 square regions is an irregularity structure formed region 510. The same applies to an irregularity structure formed region 512 in FIG. 11(A). In FIG. 10(A), each of 5 rectangular regions is an irregularity structure formed region 511. Nano-imprint is performed using such a matrix to obtain an insulating irregularity layer having a plurality of flat regions 3A and a plurality of square or rectangular light scattering regions 3B.

A matrix having an irregularity structure formed region and an irregularity structure non-formed region may be prepared by, for example, photolithography. In the photolithography method, for example, a single-crystal silicon substrate as a matrix forming material is thermally oxidized in an oxygen atmosphere to form an oxide layer on the surface, a resist is applied onto the oxide layer, and the resist is patterned by photolithography. An oxide layer exposed at the surface without being protected by the resist is removed, followed by performing wet etching to form irregularity structures only on a region which is not protected by the oxide layer, and a region protected by the resist becomes an irregularity structure non-formed region.

A matrix having an irregularity structure formed region and an irregularity structure non-formed region may also be prepared by pressing a mold, which has irregularity structures on the surface and has an area smaller than that of the matrix, to the surface of the matrix to form an irregularity structure region on part of the surface. Furthermore, the irregularity structure non-formed region 522 may be formed by digging deeper into part of the matrix 505 (see FIG. 11(B)) having irregularity structures over the entire surface as illustrated in FIG. 11. When the matrix 502 having the irregularity structure non-formed region 522 that is dug deeper than the irregularity structure formed region 512 is used as illustrated in FIG. 11, it is preferable to form irregularity structures on the light scattering region 3B of the coating layer by performing pressing so that the irregularity structure non-formed region 522 does not come into contact with the coating layer when the matrix is pressed to the coating layer of a curable material.

Among the methods described above, the photolithography method is preferable from the viewpoint of ease of preparing a matrix.

In formation of an integrated thin film solar cell, it is preferable to form the aforementioned separation grooves and connection grooves by making laser light incident in the back electrode layer 7 direction from the transparent substrate 10 side. For example, the separation grooves 214 and 314 in FIGs. 6 and 7 and the separation groove 414 in FIG. 8 may be formed by a step of removing the back electrode layer 7 together with the photoelectric conversion units 5 and 6 by performing laser irradiation after forming the back electrode layer 7. The separation groove 412 in FIG. 8 may be formed by a step of removing the transparent electrode layer by performing laser irradiation after forming the transparent electrode layer 4. The connection groove 413 may be formed by a step of removing the photoelectric conversion units 5 and 6 by performing laser irradiation after forming the photoelectric conversion units 5 and 6 and before forming the back electrode layer.

As laser light for forming separation grooves and connection grooves, a fundamental wave (1064 nm), a second harmonic wave (532 nm), a third harmonic wave (266 nm) or the like of, for example, a YAG laser or a YVO4 laser may be used. When the transparent substrate 10 has the transparent undercoat layer 2 containing fine particles, the fundamental wave and the second harmonic wave may be suitably used from the viewpoint of suppressing deterioration of processability due to light scattering at the transparent undercoat layer 2. Generally, when the transparent substrate includes a transparent undercoat layer containing fine particles, there is the concern about scattering of laser light by the irregularities at the interface between fine particles and a binder or at the surface of the transparent undercoat layer. In this respect, in the present invention, scattering of laser light by the transparent undercoat layer 2 may be suppressed by ensuring that the particle size of fine particles 21 of the transparent undercoat layer 2 and the arithmetic mean roughness of a surface of the transparent undercoat layer 2 on the insulating irregularity layer 3 side are each in a specific range.

Among the lasers described above, the second harmonic wave of the Nd-YVO4 laser is preferably used for formation of separation grooves and connection grooves. The Nd-YVO4 laser has high beam quality and is excellent in repeated oscillation in a high frequency range, and therefore high-speed scribing is possible, so that productivity of the integrated thin film solar cell may be enhanced.

With only the second harmonic wave, separation grooves and connection grooves having a proper shape may not be formed. In this case, the energy density of the laser beam should be appropriately adjusted. That is, for the second harmonic wave of the Nd-YVO4 laser, one in which the output intensity distribution of the beam cross section is made uniform and the tip part of the beam is flat is preferably used. By appropriately adjusting the energy density and the intensity distribution of laser light, uniform processing may be performed with reduced film damage at the peripheral portion of the laser processing region (wall surfaces of separation groove and connection groove).

### EXAMPLES

The present invention will be described specifically below, but the present invention is not limited to the Examples below.

### [Evaluation Method]

In the following, the thickness of each layer was measured using a spectroscopic ellipsometer VASE (manufactured by J.A. Woollam Co., Inc.). Fitting was performed using a Chaucy model.

For observation with an atomic force microscope (AFM), "Nano-R, Pacific" manufactured by Pacific Nanotechnology, Inc. was used. The surface roughness (Ra) was determined by analysis of an AFM image.

The reflectance and the transmittance were measured using a spectrophotometer ("Lambda 950" manufactured by Perkin Elmer, Inc.).

The haze was measured using a haze meter ("NDH 5000" manufactured by Nippon Denshoku Industries Co. Ltd.).

The average particle size and the coverage with fine particles in the transparent undercoat layer were measured using a scanning electron microscope ("S-4800" manufactured by Hitachi, Ltd.). In the Examples, Comparative Examples, and Reference Examples below, a transparent undercoat layer was formed by a dipping method, and therefore layers (transparent undercoat layer and anti-reflection layer) containing a binder and fine particles were formed on both surfaces of a glass base. For the average particle size and the coverage with fine particles, those measured for a surface on the transparent electrode layer forming side (transparent undercoat layer) are described in all cases, but in every Example, Comparative Example and Reference Example, a fine particle-containing layer of a surface on the light incident side (anti-reflection layer) had an average particle size and a coverage similar to those on the transparent electrode layer side (undercoat layer).

The viscosity of a solution was measured at a solution temperature of 25°C using a tuning fork vibratory viscometer manufactured by A&D Company, Limited.

### (Example 1)

### [Formation of Undercoat Layer]

An alkali-free glass plate (trade name: OA-10; manufactured by Nippon Electric Glass Co., Ltd.; thickness: 0.7 mm) was used as a glass base, and a transparent undercoat layer was formed on the glass plate.

11.90 g of an oligomer of tetraethoxysilane (polymerization degree n: 4 to 6) as a binder, and 24.38 g of an aqueous dispersion (solid content: 40%) of a silica fine particle component having an average particle size of 90 nm as fine particles were sequentially added to a mixed liquid of 24.38 g of water, 58.71 g of isopropyl alcohol and 1.14 g of 35% hydrochloric acid. The mixture was stirred/mixed at room temperature for 4 hours. Thereafter, 529.50 g of isopropanol was added as a diluent solvent, and the mixture was stirred to prepare a fine particle-containing coating solution.

A coating was performed by a dip coating method of dipping the glass base in the coating solution and drawing up the glass base at a speed of 0.1 m/minute. Dipping was performed in the following manner: the glass base was fixed to a frame body, dipped in the fine particle-containing coating solution, and then drawn up. Thereafter, a hot-air drying treatment was performed at 80°C for 30 minutes, followed by performing a firing treatment at 200°C for 5 minutes to form a transparent undercoat layer on the surface of the glass base (hereinafter, the substrate is also referred to as a "substrate with a transparent undercoat layer").

The surface at the central part in the plane of the substrate with a transparent undercoat layer was observed with an atomic force microscope (AFM), and it was found that spherical silica was uniformly dispersed and arranged in one layer as illustrated in FIG. 4. The area coverage with silica fine particles was 92%, and a dense irregularity shape was observed.

### [Preparation of Matrix]

200 g of isopropyl alcohol was added to an aqueous solution obtained by dissolving 100 g of potassium hydroxide in 1700 g of pure water, to prepare a wet etching liquid. The liquid was warmed to 70°C, and stirred by a magnetic stirrer while a single-crystal silicon wafer having the cut surface identical to a (100) plane was put therein and dipped for 30 seconds. The silicon wafer was taken out, then washed with pure water and dried. The matrix thus prepared had an irregularity pattern structure with square pyramid-shaped irregularities randomly formed on the surface. The surface of the matrix was observed with an AFM to find that the Ra was 130 nm and the Rmax was 750 nm.

### [Formation of Insulating Irregularity layer]

An insulating irregularity layer 3 was formed on the substrate with a transparent undercoat layer by the following method.

As a curable material solution, a sol-gel material solution containing 1 part by weight of a titanoxane compound based on 100 parts by weight of a siloxane-based compound (manufactured by Honeywell International, Inc. ; refractive index: 1.40; viscosity: 3.5 mPa·s) was used. This solution was applied onto the transparent undercoat layer by a spin coating method, and preliminarily dried in a drying furnace in an atmosphere of 70°C for 1 minute to form a coating layer of a thickness of 2000 nm. The matrix having an aperiodic pattern was placed on the coating layer, and hot-pressed for 5 minutes at a pressure of 3.6 MPa while a temperature of 150°C was applied. After cooling to room temperature, the matrix was released from the substrate. The substrate was fired in the air at 300°C for 1 hour to obtain a transparent substrate having an insulating irregularity layer on a transparent undercoat layer.

The surface of the insulating irregularity surface was observed with an AFM to find that the height difference of irregularity structures was 450 nm.

### [Formation of Transparent Electrode Layer]

On the insulating irregularity layer 3 of the transparent substrate, a ZnO film doped with B was formed to have a thickness of 1.6 µm as a transparent electrode layer by a low pressure CVD method. The sheet resistance of the transparent electrode layer was about 18 Ω/sq.

### [Formation of Photoelectric Conversion Unit and Back Electrode Layer]

A p-type amorphous silicon layer having a thickness of 15 nm, an intrinsic crystalline silicon photoelectric conversion layer having a thickness of 2.5 µm and an n-type microcrystalline silicon layer having a thickness of 20 nm were sequentially formed on the transparent electrode layer by a plasma-enhanced CVD method to form a pin-junction crystalline silicon photoelectric conversion unit. As a back electrode layer, an Al-doped ZnO layer having a thickness of 90 nm and an Ag layer having a thickness of 300 nm were sequentially formed on the photoelectric conversion unit by a sputtering method.

### (Example 2)

### [Formation of Undercoat Layer]

A transparent undercoat layer was formed on a glass base in the same manner as in example 1. In the obtained substrate with a transparent undercoat layer, the area coverage with silica fine particles was 90%, and a dense irregularity shape was observed.

### [Preparation of Matrix]

First, an oxide film (silicon oxide film) was formed on the surface of a single-crystal silicon wafer by thermal oxidation. A resist (photosensitive protective film) was applied by spin coating to the entire surface of the single-crystal on which the oxide film is formed. Next, using a photomask having circular openings with a diameter of 700 µm at pitches of 1000 µm, UV light with a wavelength of 365 nm was applied to expose the silicon wafer at the openings. The UV light-exposed wafer was dipped in a developer to develop a pattern of the photomask, so that a resist film was selectively formed on the wafer surface. Next, etching was performed using hydrofluoric acid (5% by weight) to selectively remove the oxide film on regions which were not protected by the resist. Further, the wafer was washed with isopropyl alcohol to remove the resist film to form the regions which were not protected by the oxide film in a two dimensional periodic-shape on the surface of the single-crystal wafer. Thereafter, by anisotropic etching using an aqueous sodium hydroxide solution (20% by weight), square pyramid-shaped recesses were formed on regions which were not protected by the oxide film, thereby preparing a matrix in which inverted pyramid-shaped recesses having a depth of 500 nm were arranged in a two-dimensional periodic-shape at intervals of 1000 nm in terms of a distance between apices.

### [Formation of Insulating Irregularity Layer]

As a curable material solution, a sol-gel material containing 5 parts by weight of a titanoxane compound based on 100 parts by weight of a siloxane-based compound (manufactured by Honeywell International, Inc.; refractive index: 1.50; viscosity: 3.3 mPa·s) was applied to the substrate with a transparent undercoat layer by a spin coating method to form a coating layer having a thickness of 2000 nm in the same manner as in Example 1. The matrix having a periodic pattern was placed on the coating layer, and heat pressing, cooling, releasing and firing were performed in the same manner as in Example 1 to obtain a transparent substrate with an insulating irregularity layer formed on a transparent undercoat layer.

The surface of the insulating irregularity layer was observed with an AFM, and it was found that the height difference of irregularity structures was 600 nm.

### [Formation of Transparent Electrode Layer, Photoelectric Conversion Unit and Back Electrode Layer]

A transparent electrode layer, a crystalline silicon photoelectric conversion unit and a back electrode layer were sequentially formed on the transparent substrate in the same manner as in Example 1.

### (Comparative Example 1)

In Comparative Example 1, a transparent undercoat layer was not formed, but an insulating irregularity layer was formed directly on a glass base. Otherwise under the same conditions as in Example 1, a thin film solar cell was prepared.

### (Comparative Example 2)

In Comparative Example 2, a transparent undercoat layer was not formed. On the surface of an insulating irregularity layer formed on a glass substrate, irregularities were formed using a matrix having a periodic irregularity pattern, which was similar to that in Example 2 Otherwise, a thin film solar cell was prepared under the same conditions as in Example 2.

### (Comparative Example 3)

In Comparative Example 3, a transparent undercoat layer and an insulating irregularity layer were not formed, but a crystalline silicon photoelectric conversion unit was formed directly on a glass base. Otherwise, a thin film solar cell was prepared under the same conditions as in Example 1.

### (Comparative Example 4)

In Comparative Example 4, an insulating irregularity layer was not formed, but a crystalline silicon photoelectric conversion unit was formed directly on an undercoat layer. Otherwise, a thin film solar cell was prepared under the same conditions as in Example 1. The transparent substrate with an undercoat layer formed on a glass base had a reflectance of 4.2% and a haze of 3.2%.

### (Comparative Example 5)

In Comparative Example 5, the amount of fine particles in a fine particle-containing coating solution for forming an undercoat layer was reduced as compared to Example 1. Otherwise, a transparent undercoat layer was formed on a glass base in the same manner as in Example 1. The area coverage with fine particles of the substrate with a transparent undercoat layer was 80%.

On the substrate with a transparent undercoat layer, an insulating irregularity layer was not formed, but a crystalline silicon photoelectric conversion unit and a back electrode layer were formed under the same conditions as in Example 1.

### (Evaluations of Examples 1 and 2 and Comparative Examples 1 to 5)

The haze of the transparent substrate and the reflectance at a wavelength of 550 nm for each of the Examples and Comparative Examples described above were measured. For Comparative Example 3 in which none of the transparent undercoat layer and the insulating irregularity layer was formed, the haze and the reflectance of the glass base were measured.

The thin film solar cell of each of the Examples and Comparative Examples described above was irradiated with pseudo-sunlight at an energy density of 100 mW/cm² under a temperature of 25°C using a solar simulator having a spectrum distribution of AM 1.5, and output characteristics were measured.

The evaluation results are shown in Table 1.

**[Table 1]**

| | transparent substrate | | | | | | | solar cell |
|---|---|---|---|---|---|---|---|---|
| | undercoat layer | | insulating irregularity layer | | | reflectance (%) | haze (%) | Jsc (mA/cm²) |
| | fine particle coverage (%) | Ra (nm) | structure | refractive index | irregularity height difference (nm) | | | |
| Example 1 | 92 | 20 | aperiodic | 1.4 | 450 | 8.6 | 57.5 | 12.8 |
| Comparative Example 1 | - | | aperiodic | 1.4 | 450 | 10.0 | 55.4 | 12.1 |
| Example 2 | 90 | 21 | periodic | 1.5 | 600 | 6.3 | 16.9 | 12.2 |
| Comparative Example 2 | - | | periodic | 1.4 | 600 | 6.9 | 13.2 | 11.7 |
| Comparative Example 3 | - | | - | | | 8.2 | 0.3 | 10.8 |
| Comparative Example 4 | 92 | 19 | - | | | 4.2 | 3.2 | 11.4 |
| Comparative Example 5 | 80 | 20 | - | | | 5.0 | 2.8 | 11.0 |

Comparison of Example 1 with Comparative Example 1 and comparison of Example 2 with Comparative Example 2 show that in Examples 1 and 2 having a transparent undercoat layer, the reflectance of the transparent substrate is reduced as compared to Comparative Examples 1 and 2. As a result, in Example 1 in which the insulating irregularity layer has an aperiodic pattern, the short-circuit current density is increased by 5.7% as compared to Comparative Example 1. In Example 2 in which the insulating irregularity layer has a periodic pattern, the short-circuit current density is increased by 4.2% as compared to Comparative Example 2. From these results, it is considered that in Examples 1 and 2 having a transparent undercoat layer, light is scattered by fine particles of the transparent undercoat layer to achieve an anti-reflection effect, resulting in improvement of the light confinement effect.

Also from the fact that in Comparative Examples 4 and 5, the reflectance of the transparent substrate is low as compared to Comparative Example 3, it can be understood that an anti-reflection effect is achieved by forming a fine particle-containing layer on a transparent substrate.

Comparison of Examples 1 and 2 with Comparative example 3 shows that in Examples 1 and 2, the haze of the transparent substrate is significantly increased as compared to Example 3. It is apparent that the haze of the transparent substrate is associated principally with light scattering at the insulating irregularity layer because the transparent substrate in Comparative example 1, which does not have a transparent undercoat layer, has a haze substantially comparable to that of the transparent substrate in Example 1. In Example 1, the short-circuit current density is increased by 18% as compared to Comparative Example 3, and in Example 2, the short-circuit current density is increased by 13% as compared to Comparative Example 3, as the haze is increased. From the results, light is scattered by the insulating irregularity layer, so that the light confinement effect is enhanced.

Comparison of Examples 1 and 2 with Comparative Examples 4 and 5 shows that in Examples 1 and 2, the reflectance of the transparent substrate is increased due to the presence of the insulating irregularity layer. The reason for this is not clear, but may be that the area of the interface between the transparent substrate and the transparent electrode layer is increased due to the presence of the insulating irregularity layer, leading to an increase in the amount of light reflection at the interface. On the other hand, in Examples 1 and 2, the haze of the transparent substrate is significantly increased as compared to Comparative Examples 4 and 5 due to the presence of the insulating irregularity layer, resulting in an increase in short-circuit current density of the thin-film solar cell.

From the results described above, it is apparent that due to the presence of the transparent undercoat layer on the transparent base, the reflectance of the transparent substrate is reduced to increase the amount of light that reaches the photoelectric conversion unit, and light is scattered by the insulating irregularity layer to increase the optical path length, so that the short-circuit current density of the thin film solar cell is increased.

Comparison of Example 1 with Example 2 shows that the short-circuit current density is more significantly increased in Example 1 in which the insulating irregularity layer has an aperiodic pattern. This is considered to be because in the case where irregularities with various height differences is formed on the surface of the insulating irregularity layer, and therefore light in a wider wavelength range is scattered and confined in the photoelectric conversion unit.

### <Evaluation of Coatability of Insulating Irregularity layer to Undercoat Layer>

In Reference Examples 1 to 3 below, the shape of the surface of the transparent undercoat layer was changed, and coatability during formation of the insulating irregularity layer on the transparent undercoat layer was evaluated.

### (Reference Example 1)

In Reference Example 1, the amount of fine particles in a fine particle-containing coating solution for forming a transparent undercoat layer was increased as compared to Example 1. Otherwise in the same manner as in Example 1, a transparent undercoat layer was formed on a glass base. The arithmetic mean roughness of the surface of the transparent undercoat layer was 19 nm, and the coverage with fine particles was 95%. An insulating irregularity layer was formed on the transparent undercoat layer in the same manner as in Example 1.

### (Reference Example 2)

In Reference Example 2, the amount of fine particles in a fine particle-containing coating solution for forming a transparent undercoat layer was decreased as compared to Example 1. Otherwise in the same manner as in Example 1, a transparent undercoat layer was formed on a glass base. The arithmetic mean roughness of the surface of the transparent undercoat layer was 55 nm, and the coverage with fine particles was 68%. An insulating irregularity layer was formed on the transparent undercoat layer in the same manner as in Example 1.

### (Reference Example 3)

In Reference Example 3, a solution (viscosity: 2.3 mPa·s) obtained by diluting the sol-gel material solution similar to that used in Example 1 to 50% by weight was applied onto a transparent undercoat layer similar to that in Reference Example 2, and heat pressing, cooling, releasing and firing was performed in the same manner as in Example 1 to form an insulating irregularity layer on the transparent undercoat layer.

### (Evaluation of Reference Examples 1 to 3)

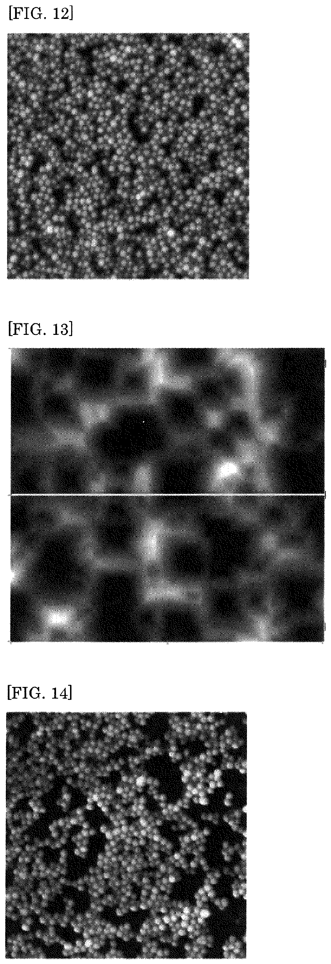

Photographs of the surface of the undercoat layer observed with an atomic force microscope (AFM) in Reference Examples 1 and 2 are shown in FIGs. 12 and 14, respectively, and photographs of surface of the insulating irregularity layer of the transparent substrate observed with an atomic force microscope (AFM) in Reference Examples 1 to 3 are shown in FIGs. 13, 15 and 16, respectively. Results of evaluating the transparent substrate are shown in Table 2. Sds in Table 2 denotes a summit density, which represents the number of points (=apices) where the height per unit area (1 µm²) is maximum. Details of definition of the summit density are as described in K.J. Stout, et al., "The development of methods for the characterization of roughness on three dimensions." Publication No. EUR 15178 of the commission of the European communities, Luxembourg. (1994).

**[Table 2]**

| | undercoat layer | | insulating irregularity layer | | | | |
|---|---|---|---|---|---|---|---|
| | fine particle coverage (%) | Ra (nm) | coating solution | refractive index | Irregularity height difference (nm) | Sds (/µm²) | evaluation result |
| Reference Example 1 | 95 | 19 | not diluted | 1.4 | 700 | 10.5 | fair |
| Reference Example 2 | 68 | 55 | not diluted | 1.4 | - | - | irregularity non-formed region is existed |
| Reference Example 3 | 68 | 55 | diluted to 50% | 1.4 | 600 | 14.3 | shape of irregularity is shrunk |

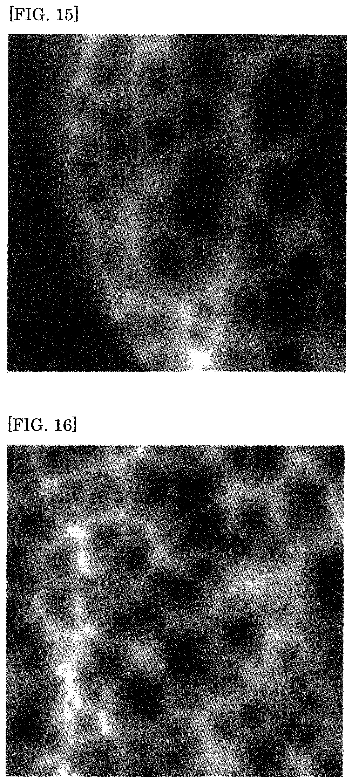

In Reference Example 2 (FIGs. 14 and 15), the Ra of the undercoat layer was large, and therefore coatability of the imprint material (sol-gel material) was poor, so that there existed an area where irregularities were not formed at a part in the plane (left side of AFM image in FIG. 15). On the other hand, in Reference Example 3, conditions for formation of the undercoat layer were identical to those in Reference Example 2, the imprint material was diluted to decrease the viscosity of the coating solution, and therefore coatability was improved, so that the insulating irregularity layer was formed over the entire surface of the undercoat layer (FIG. 16). It is considered that in Reference Example 3, the coating layer is shrunk in the curing or firing step after the matrix is pressed because the irregularity height is decreased and the summit number is increased as compared to Reference Example 1 (FIG. 13). It is thus apparent that when the coating solution is diluted, the obtained insulating irregularity layer has a small irregularity size as compared to the matrix, but has proper coatability and also proper adhesion with the undercoat layer.

From the results described above, the arithmetic mean roughness Ra of the surface of the undercoat layer is preferably small for enhancing coatability of the insulating irregularity layer and enhancing reproducibility of the irregularity size. That is, the transparent undercoat layer has preferably a high coverage with fine particles and a small average mean roughness for exhibiting an anti-reflection effect. From such a viewpoint, in the present invention, it is preferable to enhance the coverage by appropriately adjusting the content of fine particles while suppressing an excessive increase in Ra by decreasing the particle size of fine particles.

From comparison of Reference Example 2 with Reference Example 3, it is apparent that when the arithmetic mean roughness Ra of the surface of the undercoat layer is large, an insulating irregularity layer having an appropriate irregularity size is obtained by diluting an imprint material, which is used for forming the insulating irregularity layer, so as to have an appropriate viscosity. In Reference Examples 2 and 3, the content of fine particles (and coverage associated therewith) is low, and therefore the arithmetic mean roughness Ra is increased, but in such a case, coatability may be improved by diluting the imprint material (see Example 5 described below).

### <Change of Transparent Undercoat Layer and Evaluation of Thin Film Solar Cell>

### (Examples 3 to 5 and Comparative Example 6)

In Examples 3 to 5, a thin film solar cell was prepared by forming a transparent electrode layer, a photoelectric conversion unit and a back electrode layer on a transparent substrate having an undercoat layer and an insulating irregularity layer on a transparent base in the same manner as in Example 1. However, in Examples 3 to 5, the particle size and the content of fine particles of a transparent undercoat layer were changed as shown in Table 3. In Example 5, an imprint material was diluted to 50% by weight and used for formation of the insulating irregularity layer. In Comparative Example 6, an attempt was made to form an insulating irregularity layer by applying an imprint material onto an undercoat layer similar to that in Example 5 without diluting the imprint material, but there existed an area where an irregularity layer was not formed in the plane.

The evaluation results of the Examples and Comparative Example described above are shown in Table 3. In Comparative Example 6, evaluation of the short-circuit current density of a solar cell was not performed because the insulating irregularity layer was not properly formed.

**[Table 3]**

| | transparent substrate | | | | | | solar cell |
|---|---|---|---|---|---|---|---|
| | undercoat layer | | | insulating irregularity layer | | | Jsc (mA/cm²) |
| | average particle size (nm) | fine particle coverage (%) | Ra (nm) | coating solution | refractive index | irregularity height difference (nm) | |
| Example 3 | 90 | 95 | 18 | not diluted | 1.4 | 650 | 12.5 |
| Example 4 | 90 | 64 | 39 | not diluted | 1.4 | 700 | 12.0 |
| Example 5 | 300 | 97 | 53 | diluted to 50% | 1.4 | not measured | 12.2 |
| Comparative Example 6 | 300 | 97 | 53 | not diluted | 1.4 | - | - |

According to Table 3, a high current density of 12.0% or more is achieved in all of Examples 3 to 5. Particularly, the short-circuit current density was most significantly increased in Example 3 in which the fine particle coverage was high and the Ra of the undercoat layer was small.

It is thought that in Example 4, the coverage with fine particles is low as compared to Example 3, so that the reflectance of transparent substrate is higher than that in Example 3, and the short-circuit current density is low as compared to Example 3. In Example 5 and Comparative Example 6, the particle size of fine particles is large as compared to Example 3, and therefore the surface of the transparent undercoat layer has a large arithmetic mean roughness Ra. Thus, it is thought that in Comparative Example 6 in which the imprint material was used without dilution, coatability of the imprint material was poor, so that there existed an area where the insulating irregularity layer was not formed.

On the other hand, in Example 5 in which the imprint material was used after being diluted, a short-circuit current density higher than that in Example 4 was achieved although the surface of the undercoat layer had an arithmetic mean roughness higher than that in Example 4. This is thought to be because in Example 5, the reflectance of the transparent substrate was low because the coverage with fine particles in the undercoat layer was high as compared to Example 4, and a light scattering effect was achieved because the insulating irregularity layer was properly formed. In Example 5, however, the short-circuit current density was not increased as significantly as in Example 3. This is thought to be because the solid concentration of the imprint material solution was low, and therefore the size of the irregularities in the insulating irregularity layer was decreased. In Example 5, the same matrix as that in Example 3 was used, but it is considered that the short-circuit current density may also be increased to a level comparable to that in Example 3 by using, for example, a matrix having a larger irregularity pattern size (height difference).

From the above, it is apparent that when the surface of the transparent undercoat layer has a large arithmetic mean roughness Ra (irregularities formed by fine particles is large), coatability at the time of forming the insulating irregularity layer thereon is deteriorated, but by adjusting the viscosity by, for example, diluting an insulating irregularity layer forming material, coatability is improved to obtain an insulating irregularity layer having appropriate irregularities. When the solid concentration of the insulating irregularity layer forming material is low, the size of the irregularities of the insulating irregularity layer decreases, but it is considered that if the irregularity size of a matrix to be used for imprint is increased, an insulating irregularity layer having a desired irregularity size is obtained, so that a higher light confinement effect is achieved.

### <Preparation and Evaluation of Integrated Thin Film Solar Cell>

### (Reference Example 4)

As Reference Example 4, a double-junction-type thin film solar cell as illustrated in FIG. 6 was prepared.

### [Preparation of Matrix]

A single-crystal silicon wafer having the cut surface identical to a (100) plane was degreased and washed with acetone and ethanol under ultrasonic irradiation. An oxide film was formed on the surface of the washed silicon wafer by thermal oxidation. A resist was applied onto the film, patterning was performed by photolithography, followed by dipping the silicon wafer in a wet etchant similar to that in Example 1 to perform etching. In this way, a matrix having irregularity structures in a region 510 of 1 cm square (irregularity structure formed region) as illustrated in FIG. 9 was prepared.

### [Formation of Insulating Irregularity layer]

A sol-gel material similar to that used in Example 1 was applied by a spin coating method onto a glass substrate (125 mm square) identical to that used in Example 1, thereby forming a coating layer having a thickness of 1000 nm. The whole substrate provided with the coating layer was preliminarily dried on a hot plate at 60°C for 20 minutes. This substrate was delivered into an imprint device, where irregularities were transferred by a nano-imprint method using the matrix described above. This substrate was fired in the air at 400°C for 1 hour to obtain a transparent substrate in which an insulating irregularity layer having a flat region 3A and a light scattering region (irregularities formed region) 3B was formed on a glass base.

The cross-sectional shape of this substrate was observed at a cross-sectional length of 3.5 µm using a transmission electron microscope (TEM, TITAN 80 manufactured by FEI Company) and it was found that irregularity structures in the light scattering region were adjacent to one another, the height difference thereof was in a range of 200 nm to 600 nm (average 500 nm), and the distance between apices of projections was in a range of 300 nm to 1200 nm (average 700 nm). When light is made incident from a surface of the substrate, which was not provided with irregularity structures, and the transmittance was measured using a spectrophotometer (Lambda 950 manufactured by Perkin Elmer, Inc.), a transmittance of 85% or more was shown in a wavelength range of 400 to 1200 nm.

### [Formation of Transparent Electrode Layer]

As a transparent electrode layer, ZnO was deposited in a thickness of 1.5 µm on the insulating irregularity layer of the transparent substrate. First, the transparent substrate was delivered into a deposition chamber, and the substrate temperature was controlled to 150°C. Thereafter, 1000 sccm of hydrogen, 500 sccm of diborane diluted to 5000 ppm with hydrogen, 100 sccm of water and 50 sccm of diethyl zinc were introduced into the deposition chamber, where a deposition was carried out at 10 Pa. The height difference of irregularity structures of this transparent conductive layer was 40 to 200 nm, the distance between apices of projections was 100 to 500 nm, and the sheet resistance was 12 Ω/sq.

### [Formation of Photoelectric Conversion Unit and Back Electrode Layer]

The substrate with a transparent electrode layer was introduced into a plasma-enhanced CVD device, where a boron-doped p-type amorphous silicon carbide (SiC) layer having a thickness of 10 nm, a non-doped i-type amorphous silicon conversion layer having a thickness of 300 nm, and a phosphorus-doped n-type microcrystalline silicon layer having a thickness of 20 nm were sequentially formed to form an amorphous silicon photoelectric conversion unit. A boron-doped p-type microcrystalline silicon layer having a thickness of 15 nm, a non-doped i-type crystalline silicon conversion layer having a thickness of 700 nm, and a phosphorus-doped n-type microcrystalline silicon layer having a thickness of 20 nm were sequentially formed thereon to form a crystalline silicon photoelectric conversion unit. A ZnO layer having a thickness of 80 nm and an Ag layer having a thickness of 300 nm were further formed thereon as a back electrode layer by a sputtering method.

### [Formation of Separation Groove]

A separation groove 214, with which an area extending from the photoelectric conversion unit to the back electrode layer was removed, was formed by laser scribing utilizing the second harmonic wave of a Nd-YVO4 laser, the output intensity distribution of which was made uniform, and incident from the glass base side. This separation groove was formed on a flat region of the transparent substrate. Laser processing conditions included a Q switch frequency of 20 kHz, a processing speed of 400 mm/sec, a processing point power of 0.3 W and a beam diameter of 30 µm.

### (Comparative Example 7)

In Comparative Example 7, a double-junction-type thin film silicon solar cell was prepared in the same manner as in Reference Example 4, but Comparative Example 7 was different from Reference Example 4 in that a silicon wafer provided with irregularity structures over the entire surface was used as a matrix for forming of an insulating irregularity layer. That is, in Comparative Example 7, an insulating irregularity layer having no flat region and having only a light scattering region was formed by a nano-imprint method using as a matrix a silicon wafer provided over the entire surface with a pyramid-shaped irregularity structures having an average height difference of 600 nm.

An amorphous photoelectric conversion unit, a crystalline silicon photoelectric conversion unit and a back electrode were formed, in the same manner as in Reference Example 4, on the insulating irregularity layer, followed by forming a separation groove to prepare a thin film solar cell having a light reception area of 1 cm square.

### (Reference Example 5)

As Reference Example 5, an integrated double-junction thin film solar cell similar to that in FIG. 8 was prepared. However, the thin film solar cell in Reference Example 5 is different from the thin film solar cell in FIG. 8 in that the transparent substrate 10 has no transparent undercoat layer 2, and the insulating irregularity layer 3 is formed on the transparent base 1.

In Reference Example 5, an insulating irregularity layer and a transparent electrode layer were formed on a glass base by the same method as that in Reference Example 4, but Reference Example 5 was different from Reference Example 4 in that a matrix having irregularity structures on a rectangular region 511 (irregularity structure formed region) as illustrated in FIG. 10 was used in nano-imprint of the insulating irregularity layer.

### [Formation of Transparent Electrode Layer Separation Groove]

By laser scribing utilizing the fundamental wave of an Nd-YVO4 laser incident from the glass base side, the transparent electrode layer was removed to form a separation groove 412. This separation groove was formed on a flat region of the transparent substrate. Laser processing conditions included a Q switch frequency of 20 kHz, a processing speed of 400 mm/sec, a processing point power of 5 W and a beam diameter of 30 µm.

### [Formation of Photoelectric Conversion Unit and Connection Groove]

An amorphous silicon photoelectric conversion unit and a crystalline silicon photoelectric conversion unit were formed, in the same manner as in Reference Example 4, on the transparent electrode layer. A connection groove 413, with which an area extending from the amorphous photoelectric conversion unit to the crystalline silicon photoelectric conversion unit was removed, was formed by laser scribing utilizing the second harmonic wave of a Nd-YVO4 laser, the output intensity distribution of which was made uniform, and incident from the glass base side. The connection groove 413 was formed on a flat region of the transparent substrate. Laser processing conditions included a Q switch frequency of 20 kHz, a processing speed of 400 mm/sec, a processing point power of 0.3 W and a beam diameter of 30 µm.

### [Formation of Back Electrode Layer and Back Electrode Layer Separation Groove]

In the same manner as in Reference Example 4, a back electrode layer was formed on the crystalline silicon photoelectric conversion unit, and separation groove 414, with which an area extending from the photoelectric conversion unit to the back electrode layer was removed, was formed by laser scribing utilizing the second harmonic wave of a Nd-YVO4 laser incident from the glass base side. This separation groove was formed on a flat region of the transparent substrate. Laser processing conditions were identical to the laser processing conditions during formation of the separation groove 214 in Reference Example 4.

From the above, an integrated double-junction-type thin film silicon solar cell with 5 rows of photoelectric conversion cells connected in series on a substrate of 125 mm square was formed.

### (Comparative Example 8)

In Comparative Example 8, a double-junction-type thin film silicon solar cell was prepared in the same manner as in Reference Example 5, but Comparative Example 8 was different from Reference Example 5 in that a silicon wafer provided with irregularity structures over the entire surface was used as a matrix for forming of an insulating irregularity layer. That is, in Comparative Example 8, an insulating irregularity layer having no flat region and having only a light scattering region was formed by a nano-imprint method using as a matrix a silicon wafer provided over the entire surface with pyramid-shaped irregularity structures having a height difference of 600 nm.

A transparent electrode layer, a transparent electrode layer separation groove, a photoelectric conversion unit, a connection groove, a back electrode layer and a back electrode separation groove were sequentially formed, in the same manner as in Reference Example 5, on the insulating irregularity layer to form an integrated double-junction-type thin film silicon solar cell with 5 rows of photoelectric conversion cells connected in series on a substrate of 125 mm square.

### (Example 6)

In Example 6, an integrated double-junction thin film solar cell illustrated in FIG. 8 was prepared. That is, in Example 6, a transparent substrate, in which a transparent undercoat layer formed of fine particles and a binder was formed on a transparent base and an insulating irregularity layer was formed thereon, was used. Conditions for formation of the transparent undercoat layer were identical to those in Example 1. Otherwise in the same manner as in Reference Example 5, an integrated double-junction-type thin film silicon solar cell with 5 rows of photoelectric conversion cells connected in series on a substrate of 125 mm square was formed.

### (Evaluation of Example 6, Reference Examples 4 and 5 and Comparative Examples 7 and 8)

Conversion characteristics (short-circuit current density (Jsc), open circuit voltage (Voc), fill factor (F.F.) and photoelectric conversion efficiency (Eff.)) of the thin film solar cells in Example 6, Reference Examples 4 and 5 and Comparative Examples 7 and 8 were evaluated using a solar simulator in the same manner as in Example 1. For the solar cells in Reference Example 4 and Comparative Example 7, evaluation of characteristics in a photoelectric conversion region of 1 cm square (light scattering region) was performed. For the integrated photoelectric conversion devices in Example 6, Reference Example 5 and Comparative Example 8, evaluation of characteristics in one row of cells was performed.

The characteristics of the transparent substrates used in the Examples, Reference Examples, and Comparative Examples described above, and result

**[Table 4]**

| | transparent substrate | | | | | | | solar cell | | | |
|---|---|---|---|---|---|---|---|---|---|---|---|
| | undercoat layer | | | insulating irregularity layer | | haze (%) | | Jsc (mA/cm²) | Voc (V) | F.F. (%) | Eff. (%) |
| | average particle size (nm) | fine particle overage (%) | Ra (nm) | refractive index | irregularity height difference (nm) | flat region | light scattering region | | | | |
| Reference Example 4 | - | | | 1.4 | 680 | 2 | 50 | 10.6 | 1.37 | 72.0 | 10.5 |
| Comparative Example 7 | - | | | 1.4 | 700 | - | 50 | 10.0 | 1.30 | 62.3 | 8.1 |
| Reference Example 5 | - | | | 1.4 | 720 | 3 | 50 | 10.9 | 1.37 | 71.5 | 10.7 |
| Comparative Example 8 | - | | | 1.4 | 750 | - | 50 | 10.7 | 1.35 | 62.0 | 9.0 |
| Example 6 | 300 | 97 | 53 | 1.4 | 800 | 4 | 52 | 11.3 | 1.37 | 72.5 | 11.2 |

Comparison of Reference Example 4 with Comparative Example 7 shows that in Reference Example 4, all of the short-circuit current density, the open circuit voltage and the fill factor were higher as compared to Comparative Example 7, and the conversion efficiency was increased by 2.4%. Also, in Reference Example 5, all of the short-circuit current density, the open circuit voltage and the fill factor were higher as compared to Comparative Example 8, and the conversion efficiency was increased by 1.7%. This is considered to be because in Reference Examples 4 and 5, the light scattering region of the transparent substrate was not irradiated with laser beams for formation of a separation groove and a connection groove, and therefore scattering of beams was suppressed, so that damage to the photoelectric conversion region was reduced.

In Example 6 in which an undercoat layer having fine particles and a binder was formed between the glass base and the insulating irregularity layer, the short-circuit current density was increased, resulting in improvement of the conversion efficiency, as compared to Reference Example 5. This is considered to be because the light confinement effect was further enhanced by the anti-reflection effect of the transparent undercoat layer.

In Example 6, although an undercoat layer containing fine particles was formed and fine irregularity interfaces were formed in the flat area, the fill factor was not reduced, but rather improved, as compared to Reference Example 5. From this fact, it is considered that in Example 6, scattering of laser beams at the transparent substrate is suppressed, so that damage to the photoelectric conversion region is reduced. The reason why the fill factor was improved as compared to Reference Example 5 may be that in Example 6, adhesion of the insulating irregularity layer was improved due to the presence of the undercoat layer, so that film peeling at the laser processing portion was suppressed.

### DESCRIPTION OF REFERENCE CHARACTERS

- 100 :: thin film solar cell
- 10 :: transparent substrate
- 1 :: transparent base
- 2 :: transparent undercoat layer
- 9 :: anti-reflection layer
- 21, 91 :: fine particle
- 22, 92 :: binder
- 3: insulating irregularity layer
- 3A: flat region
- 3B: light scattering region
- 4: transparent electrode layer
- 5, 6: photoelectric conversion unit
- 51, 61: p-type layer
- 52, 62: photoelectric conversion layer
- 53, 63: n-type layer
- 7: back electrode layer
- 71: conductive oxide layer
- 72: metal layer
- 214, 314: separation groove
- 412: transparent electrode layer separation groove
- 413: connection groove
- 414: back electrode layer separation groove
- 500-502: matrix

## Claims

1. A thin film solar cell, comprising: a transparent substrate; a transparent electrode layer; at least one photoelectric conversion unit; and a back electrode layer in this order from a light incident side,
wherein the transparent substrate comprises a transparent base; a transparent undercoat layer containing fine particles and a binder; and an insulating irregularity layer in this order from the light incident side, and
the insulating irregularity layer has a refractive index of 1.40 to 1.65, and has an irregularity pattern on a surface on a transparent electrode layer side; wherein in the insulating irregularity layer, a height difference of the irregularity pattern is 300 nm to 2000 nm, and
wherein an arithmetic mean roughness Ra of a surface of the transparent undercoat layer on an insulating irregularity layer side is 5 nm to 65 nm.

2. The thin film solar cell according to claim 1, wherein in the transparent undercoat layer, an area coverage with the fine particles is 80% or more.

3. The thin film solar cell according to any one of claims 1 or 2, wherein the fine particles in the transparent undercoat layer have an average particle size of 10 nm to 350 nm.

4. The thin film solar cell according to any one of claims 1 to 3, wherein the insulating irregularity layer has a siloxane-based compound as a main component.

5. The thin film solar cell according to any one of claims 1 to 4, wherein the transparent substrate comprises an anti-reflection layer on the light incident side of the transparent base, and
the anti-reflection layer comprises fine particles and a binder.

6. The thin film solar cell according to any one of claims 1 to 5, wherein the thin film solar cell comprises a plurality of photoelectric conversion regions and a plurality of non-photoelectric conversion regions,
the transparent electrode layer, the at least one photoelectric conversion unit, and the back electrode layer are divided by separation grooves formed in the plurality of non-photoelectric conversion regions, so as to form a plurality of photoelectric conversion cells,
the transparent substrate comprises a plurality of light scattering regions and a plurality of flat regions, and a haze in the light scattering region is larger than a haze in the flat region, and
each of the non-photoelectric conversion regions overlaps at least part of one of the flat regions.

7. The thin film solar cell according to claim 6, wherein the transparent electrode layer is divided into a plurality of regions by a transparent electrode layer separation groove,
the photoelectric conversion unit and the back electrode layer are divided into a plurality of regions by a back electrode layer separation groove, so that a plurality of photoelectric conversion cells are formed, and
a connection groove formed in the photoelectric conversion unit is filled with a conductive material which forms the back electrode layer, so that the transparent electrode layer and the back electrode layer are electrically connected, and adjacent photoelectric conversion cells are connected in series.

8. The thin film solar cell according to claim 6 or 7, wherein in the insulating irregularity layer, a height difference of the irregularity pattern of a surface on the transparent electrode layer side in the light scattering region is larger than a height difference of the irregularity pattern of a surface on the transparent electrode layer side in the flat region.

9. The thin film solar cell according to any one of claims 6 to 8, wherein in the transparent substrate, the haze of the light scattering region is 10 to 50%, and the haze of the flat region is 10% or less.

10. The thin film solar cell according to any one of claims 6 to 9, wherein each of the plurality of non-photoelectric conversion regions is formed in one of the plurality of flat regions.

11. A method for manufacturing the thin film solar cell according to any one of claims 1 to 10,
wherein the insulating irregularity layer is formed by the steps of:
forming a coating layer by applying a coating solution containing a curable material;
preliminarily drying the coating layer;
pressing to the preliminarily dried coating layer a matrix having an irregularity pattern;
curing the curable material of the coating layer; and
releasing the matrix from the cured coating layer.

12. The method for manufacturing a thin film solar cell according to claim 11, wherein a viscosity of the coating solution is 0.1 mPa·s to 10 mPa·s.

13. The method for manufacturing a thin film solar cell according to claim 11 or 12, wherein a height difference of the irregularity pattern of the matrix is 1.1 to 1.4 times a height difference of the irregularity pattern of the insulating irregularity layer.

14. The method for manufacturing the thin film solar cell according to claim 11, wherein the thin film solar cell is as defined in claim 6 or 7 and
wherein the separation groove is formed by making laser light incident from a transparent substrate side.

## Patentansprüche

1. Dünnschichtsolarzelle, umfassend: ein transparentes Substrat; eine transparente Elektrodenschicht; mindestens eine photoelektrische Umwandlungseinheit; und eine hintere Elektrodenschicht in dieser Reihenfolge, ausgehend von einer Lichteinfallseite,
wobei das transparente Substrat eine transparente Basis; eine transparente Unterschicht, die feine Teilchen und ein Bindemittel enthält; und eine Isolationsschicht mit Unregelmäßigkeiten in dieser Reihenfolge, ausgehend von der Lichteinfallseite, umfasst, und
die Isolationsschicht mit Unregelmäßigkeiten einen Brechungsindex von 1,40 bis 1,65 und ein unregelmäßiges Muster auf einer Oberfläche auf der Seite der transparenten Elektrodenschicht aufweist;
wobei in der Isolationsschicht mit Unregelmäßigkeiten die Höhendifferenz des unregelmäßigen Musters 300 nm bis 2000 nm beträgt, und
die arithmetische mittlere Rauhigkeit Ra der Oberfläche der transparenten Unterschicht auf der Seite der Isolationsschicht mit Unregelmäßigkeiten 5 nm bis 65 nm beträgt.

2. Dünnschichtsolarzelle gemäß Anspruch 1, wobei die transparente Unterschicht eine Flächenbedeckung mit den feinen Teilchen von 80% oder mehr aufweist.

3. Dünnschichtsolarzelle gemäß einem der Ansprüche 1 oder 2, wobei die feinen Teilchen in der transparenten Unterschicht eine mittlere Teilchengröße von 10 nm bis 350 nm aufweisen.

4. Dünnschichtsolarzelle gemäß einem der Ansprüche 1 bis 3, wobei die Isolationsschicht mit Unregelmäßigkeiten eine Verbindung auf Siloxanbasis als Hauptkomponente aufweist.

5. Dünnschichtsolarzelle gemäß einem der Ansprüche 1 bis 4, wobei das transparente Substrat auf der Lichteinfallseite der transparenten Basis eine Antireflexionsschicht aufweist und die Antireflexionsschicht feine Teilchen und ein Bindemittel umfasst.

6. Dünnschichtsolarzelle gemäß einem der Ansprüche 1 bis 5, wobei die Dünnschichtsolarzelle eine Vielzahl von photoelektrischen Umwandlungsbereichen und eine Vielzahl von nicht-photoelektrischen Umwandlungsbereichen umfasst,
die transparente Elektrodenschicht, die mindestens eine photoelektrische Umwandlungseinheit, und die hintere Elektrodenschicht durch Trennungsrillen unterteilt sind, die in der Vielzahl von nicht-photoelektrischen Umwandlungsbereichen ausgebildet sind, um eine Vielzahl von photoelektrischen Umwandlungszellen zu bilden,
das transparente Substrat eine Vielzahl von Lichtstreuungsbereichen und eine Vielzahl von flachen Bereichen umfasst, und die Trübung im Lichtstreuungsbereich größer ist, als die Trübung im flachen Bereich, und
jeder der nicht-photoelektrischen Umwandlungsbereiche mit mindestens einem Teil eines der flachen Bereiche überlappt.

7. Dünnschichtsolarzelle gemäß Anspruch 6, wobei die transparente Elektrodenschicht durch eine Trennungsrille der transparenten Elektrodenschicht in mehrere Bereiche unterteilt ist,
die photoelektrische Umwandlungseinheit und die hintere Elektrodenschicht durch eine Trennungsrille der hinteren Elektrodenschicht in eine Vielzahl von Bereichen unterteilt sind, um eine Vielzahl von photoelektrischen Umwandlungszellen zu bilden, und
eine Verbindungsrille, die in der photoelektrischen Umwandlungseinheit gebildet ist, mit einem leitfähigen Material gefüllt ist, das die hintere Elektrodenschicht bildet, so dass die transparente Elektrodenschicht und die hintere Elektrodenschicht elektrisch verbunden sind, und benachbarte photoelektrische Umwandlungszellen in Reihe geschaltet sind.

8. Dünnschichtsolarzelle gemäß Anspruch 6 oder 7, wobei in der Isolationsschicht mit Unregelmäßigkeiten, die Höhendifferenz des unregelmäßigen Musters auf der Oberfläche auf der Seite der transparenten Elektrodenschicht im Lichtstreuungsbereich größer ist, als die Höhendifferenz des unregelmäßigen Musters auf der Oberfläche auf der Seite der transparenten Elektrodenschicht im flachen Bereich.

9. Dünnschichtsolarzelle gemäß einem der Ansprüche 6 bis 8, wobei in dem transparenten Substrat, die Trübung des Lichtstreuungsbereichs 10 bis 50% beträgt und die Trübung des flachen Bereichs 10% oder weniger beträgt.

10. Dünnschichtsolarzelle gemäß einem der Ansprüche 6 bis 9, wobei jeder der Vielzahl von nicht-photoelektrischen Umwandlungsbereichen in einem der Vielzahl von flachen Bereichen ausgebildet ist.

11. Verfahren zur Herstellung der Dünnschichtsolarzelle gemäß einem der Ansprüche 1 bis 10,
wobei die Isolationsschicht mit Unregelmäßigkeiten durch die folgenden Schritte gebildet wird:
Bilden einer Überzugsschicht durch Aufbringen einer Beschichtungslösung, die ein härtbares Material enthält;
Vortrocknen der Überzugsschicht;
Pressen einer Matrix mit einem unregelmäßigen Muster auf die vorgetrocknete Überzugsschicht;
Härten des härtbaren Materials der Überzugsschicht; und
Ablösen der Matrix von der gehärteten Überzugsschicht.

12. Verfahren zur Herstellung einer Dünnschichtsolarzelle gemäß Anspruch 11, wobei die Viskosität der Beschichtungslösung 0,1 mPa·s bis 10 mPa·s beträgt.

13. Verfahren zur Herstellung einer Dünnschichtsolarzelle gemäß Anspruch 11 oder 12, wobei die Höhendifferenz des unregelmäßigen Musters der Matrix das 1,1- bis 1,4-fache der Höhendifferenz des unregelmäßigen Musters der Isolationsschicht mit Unregelmäßigkeiten beträgt.

14. Verfahren zur Herstellung der Dünnschichtsolarzelle gemäß Anspruch 11, wobei die Dünnschichtsolarzelle wie in Anspruch 6 oder 7 definiert ist, und wobei die Trennungsrille gebildet wird, indem Laserlicht von einer transparenten Seite des Substrats eingestrahlt wird.

## Revendications

1. Photopile à film mince, comprenant: un substrat transparent; une couche d'électrode transparente ; au moins une unité de conversion photoélectrique ; et une couche d'électrode arrière dans cet ordre depuis un côté incident de la lumière,
dans laquelle le substrat transparent comprend une base transparente; une couche de sous-revêtement transparente contenant de fines particules et un liant; et une couche d'irrégularité isolante dans cet ordre depuis le côté incident de la lumière, et
la couche d'irrégularité isolante présente un indice de réfraction de 1,40 à 1,65, et a un motif d'irrégularité sur une surface sur un côté couche d'électrode transparente ;
dans laquelle, dans la couche d'irrégularité isolante, une différence de hauteur du motif d'irrégularité est de 300 nm à 2000 nm, et
dans laquelle une rugosité moyenne arithmétique Ra d'une surface de la couche de sous-revêtement transparente sur un côté couche d'irrégularité isolante est de 5 nm à 65 nm.

2. Photopile à film mince selon la revendication 1, dans laquelle dans la couche de sous-revêtement transparente, une couverture de surface avec les particules fines est de 80 % ou plus.

3. Photopile à film mince selon l'une quelconque des revendications 1 ou 2, dans laquelle les fines particules dans la couche de sous-revêtement transparente ont une taille de particule moyenne de 10 nm à 350 nm.

4. Photopile à film mince selon l'une quelconque des revendications 1 à 3, dans laquelle la couche d'irrégularité isolante a un composé à base de siloxane comme composant principal.

5. Photopile à film mince selon l'une quelconque des revendications 1 à 4, dans laquelle le substrat transparent comprend une couche antireflet sur le côté incident de la lumière de la base transparente, et
la couche antireflet comprend de fines particules et un liant.

6. Photopile à film mince selon l'une quelconque des revendications 1 à 5, dans laquelle la photopile à film mince comprend une pluralité de régions de conversion photoélectrique et une pluralité de régions de non-conversion photoélectrique,
la couche d'électrode transparente, l'au moins une unité de conversion photoélectrique et la couche d'électrode arrière sont divisées par des rainures de séparation formées dans la pluralité de régions de non-conversion photoélectrique, de manière à former une pluralité de cellules de conversion photoélectrique,
le substrat transparent comprend une pluralité de régions de dispersion de lumière et une pluralité de régions plates, et un voile dans la région de dispersion de lumière est plus grand qu'un voile dans la région plate, et
chacune des régions de non-conversion photoélectrique chevauche au moins une partie d'une des régions plates.

7. Photopile à film mince selon la revendication 6, dans laquelle la couche d'électrode transparente est divisée en une pluralité de régions par une rainure de séparation de couche d'électrode transparente,
l'unité de conversion photoélectrique et la couche d'électrode arrière sont divisées en une pluralité de régions par une rainure de séparation de couche d'électrode arrière, de telle sorte qu'une pluralité de cellules de conversion photoélectrique sont formées, et
une rainure de connexion formée dans l'unité de conversion photoélectrique est remplie d'un matériau conducteur qui forme la couche d'électrode arrière, de telle sorte que la couche d'électrode transparente et la couche d'électrode arrière sont électriquement connectées, et des cellules de conversion photoélectrique adjacentes sont connectées en série.

8. Photopile à film mince selon la revendication 6 ou 7, dans laquelle, dans la couche d'irrégularité isolante, une différence de hauteur du motif d'irrégularité d'une surface sur le côté couche d'électrode transparente dans la région de dispersion de lumière est plus grande qu'une différence de hauteur du motif d'irrégularité d'une surface sur le côté couche d'électrode transparente dans la région plate.

9. Photopile à film mince selon l'une quelconque des revendications 6 à 8, dans laquelle, dans le substrat transparent, le voile de la région de dispersion de lumière est de 10 à 50 %, et le voile de la région plate est de 10 % ou moins.

10. Photopile à film mince selon l'une quelconque des revendications 6 à 9, dans laquelle chacune de la pluralité de régions de non-conversion photoélectrique est formée dans l'une de la pluralité de régions plates.

11. Procédé pour fabriquer la photopile à film mince selon l'une quelconque des revendications 1 à 10,
dans lequel la couche d'irrégularité isolante est formée par les étapes de :
formation d'une couche de revêtement en appliquant une solution de revêtement contenant un matériau durcissable ;
séchage préalable de la couche de revêtement ;
pressage sur la couche de revêtement préalablement séchée d'une matrice ayant un motif d'irrégularité ;
durcissement du matériau durcissable de la couche de revêtement ; et
libération de la matrice de la couche de revêtement durcie.

12. Procédé pour fabriquer une photopile à film mince selon la revendication 11, dans lequel une viscosité de la solution de revêtement est de 0,1 mPa·s à 10 mPa·s.

13. Procédé pour fabriquer une photopile à film mince selon la revendication 11 ou 12, dans lequel une différence de hauteur du motif d'irrégularité de la matrice est de 1,1 à 1,4 fois une différence de hauteur du motif d'irrégularité de la couche d'irrégularité isolante.

14. Procédé pour fabriquer la photopile à film mince selon la revendication 11, dans lequel la photopile à film mince est telle que définie selon la revendication 6 ou 7 et
dans lequel la rainure de séparation est formée en rendant une lumière laser incidente depuis un côté substrat transparent.
